(19)

Europäisches Patentamt

European Patent Office

Office européen des brevets

(11) **EP 3 408 936 B1**

(12) **EUROPEAN PATENT SPECIFICATION**

(45) Date of publication and mention of the grant of the patent:
**04.12.2019 Bulletin 2019/49**

(51) Int Cl.:
*H03F 1/30* (2006.01)    *H03F 3/183* (2006.01)
*H03F 3/45* (2006.01)    *H04R 5/04* (2006.01)
*H03F 3/68* (2006.01)    *H03G 3/00* (2006.01)
*H04R 29/00* (2006.01)    *H04S 7/00* (2006.01)
*H02M 1/32* (2007.01)    *H02M 1/42* (2007.01)
*H05B 37/02* (2006.01)    *H02M 1/00* (2006.01)
*H03F 3/217* (2006.01)    *H03G 3/30* (2006.01)

(21) Application number: **17703640.7**

(22) Date of filing: **27.01.2017**

(86) International application number:
**PCT/US2017/015476**

(87) International publication number:
**WO 2017/132594 (03.08.2017 Gazette 2017/31)**

(54) **MULTI-CHANNEL AMPLIFIER WITH CONTINUOUS CLASS-D MODULATOR AND EMBEDDED PLD AND RESONANT FREQUENCY DETECTOR**

MEHRKANALVERSTÄRKER MIT KONTINUIERLICHEM KLASSE-D-MODULATOR UND EINGEBETTETEM PLD UND RESONANZFREQUENZDETEKTOR

AMPLIFICATEUR MULTICANAL AVEC MODULATEUR CONTINU DE CLASSE D ET DISPOSITIF LOGIQUE PROGRAMMABLE ET DÉTECTEUR DE FRÉQUENCE DE RÉSONANCE INTÉGRÉS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:    **29.01.2016 EP 16153471**
**29.01.2016 US 201662289037 P**
**02.12.2016 US 201662429662 P**
**02.12.2016 US 201662429682 P**
**25.01.2017 US 201762450543 P**

(43) Date of publication of application:
**05.12.2018 Bulletin 2018/49**

(73) Proprietor: **Dolby Laboratories Licensing Corporation**
**San Francisco, CA 94103 (US)**

(72) Inventors:
• **VOGEL, Erich H**
**San Francisco, California 94103 (US)**
• **BUTLER, JOEL A.**
**San Francisco, California 94103 (US)**
• **REVELLI, Luca**
**San Francisco, California 94103 (US)**

(74) Representative: **Dolby International AB**
**Patent Group Europe**
**Apollo Building, 3E**
**Herikerbergweg 1-35**
**1101 CN Amsterdam Zuidoost (NL)**

(56) References cited:
**EP-A1- 2 387 149        EP-A1- 2 387 149**
**EP-A1- 2 562 931        WO-A1-2008/037261**
**WO-A1-2009/070004      WO-A1-2009/070004**
**WO-A2-01/71905          WO-A2-2007/087586**
**JP-A- S59 176 913      US-A1- 2005 162 223**
**US-A1- 2006 082 414    US-A1- 2007 069 930**
**US-A1- 2007 247 219    US-A1- 2009 160 547**
**US-A1- 2009 315 623    US-A1- 2010 239 102**
**US-A1- 2010 239 102**

## Description

### CROSS-REFERENCE TO RELATED APPLICATIONS

This application claims priority to European Patent Application No. 16153471.4 filed 29 January 2016; United States Patent Application No. 62/289,037 filed 29 January 2016; United States Patent Application No. 62/429,682 filed 2 December 2016; United States Patent Application No. 62/429,662 filed 2 December 2016 and United States Patent Application No. 62/450,543 filed January 25, 2017.

### FIELD OF THE INVENTION

One or more implementations relate generally to audio power amplifiers, and more specifically to a multichannel power amplifier with a programmable logic device (PLD)-implemented continuous time Class-D pulsewidth modulated modulator and control loop, and a resonant or high-frequency detector.

### BACKGROUND

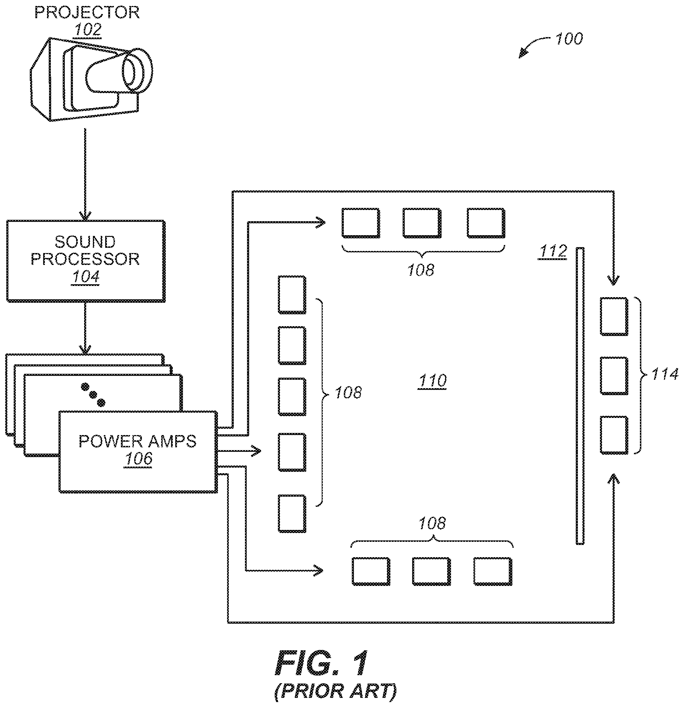

Cinema sound has undergone significant changes with the advent of digital audio, digital cinema, and new immersive audio formats, such as Dolby Atmos®. Many channels of audio are now available for playback through extensive arrays of speaker in many large cinema environments. For large venues, the power requirements and the burdens placed on amplifier stages can be significant. FIG. 1 illustrates an example cinema environment having a surround sound speaker array powered by multiple power amplifiers as presently known. As shown in FIG. 1, a cinema or similar audio/visual (A/V) listening environment 110 has a screen 112 and a set or array of speakers 108 placed around the periphery of the listening environment 110 in any appropriate surround sound arrangement, such as 5.1, 7.1, 9.1 and so on. For the example of FIG. 1, speakers 114 may be Left (L), Center (C), Right (R) speakers along with a low frequency effects (LFE) speaker (not shown), and set or array of speakers 108 may be surround speakers in any appropriate configuration. For immersive audio playback, set or array of speakers 108 may also include overhead mounted height speakers (not shown). In a typical cinema or A/V application, the audio content is provided by projector 102 through a sound processor 104 and then to power amplifiers 106 to drive the speakers through individual speaker feeds.

The number of power amps needed to drive the speakers depends on the size of the venue and the size/type of speakers, as well as the audio content. In a modern cinema environment, a large number of power amps may be required. For example, a typical cinema installation with 200-300 seats and a screen size of 40' or greater may require on the order of 12 two-channel amplifiers in the amp array 106. Such an array of amplifiers requires substantial electrical circuitry and takes up a significant amount of space (e.g., two or more full height racks) and can also generate a lot of heat. This can be an issue in theatres that have small control booths with limited space and HVAC capabilities. Present cinema amplifier systems also do not dynamically accommodate changes in power requirements or environmental/operating conditions. One study of Atmos theatre content has shown that the combined power across all Atmos overhead speakers rarely gets above 300W summed, although there are times when 300W is needed per channel over a very limited time period. Present amplifier systems cannot share or steer power among the appropriate speakers in a manner that accommodates different per channel requirements. This issue is exacerbated with immersive audio content in which channel-based audio is augmented with a spatial presentation of sound utilizes audio objects, which are audio signals with associated parametric descriptions of apparent position (e.g., 3D coordinates), apparent width, and other parameters. Such immersive audio content may be used for many multimedia applications, such as movies, video games, simulators, and can benefit from a flexible configuration and arrangement of speakers within the listening environment. A main advantage of immersive audio systems over traditional channel-based surround sound systems is the accurate representation of audio content around and above the listener as represented at least in part by height cues in the audio content. Optimal power sharing and steering of speaker feeds for arrays of speakers is particularly beneficial for this type of application, and is not met by present amplifier systems.

To improve overall efficiency audio amplifiers may employ Class-D amplifier circuits, which offer significant power-efficiency advantages over linear audio-amplifier classes such as Class A, B, and AB that feature serious amounts of power loss due to biasing elements and the linear operation of output transistors. Basic Class-D amplifiers use pulse-width modulation (PWM) with a triangle-wave (or sawtooth) oscillator. In a general design, the circuit comprises a PWM, two output transistors (e.g., MOSFETs) and an external low-pass filter to recover the amplified audio signal. The output transistors switch the output to either $V_{DD}$ or ground to produce a high-frequency square wave, which is pulse-width modulated by the input audio signal. Modulation is accomplished by comparing the input audio signal to an internally generated triangle-wave (or sawtooth) oscillator, which acts as the sampling clock. The resulting duty cycle of the square wave is proportional to the level of the input signal, and when no input signal is present, the duty cycle of the output waveform is equal to 50%.

A significant requirement of high-power amplifiers that drive a high number of separate channels is maintaining synchronization with the carrier signal and providing stability against low-frequency oscillations at the resonant frequency of the circuit. Present amplifier systems that may be employed for high-power and high-channel count applications typically utilize non-efficient linear amplifiers, or efficient Class-D amplifiers that do not provide adequate synchronization and stability features for use in applications such as digital cinema systems.

US2010/0239102, EP2387149, WO2005099098 and US2009/0160547 represent further relevant teachings in the field of audio class-D amplifiers.

BRIEF SUMMARY OF EMBODIMENTS

The object of the invention is achieved by the independent claims 1 and 2. A further embodiment is defined by the dependent claim 3.

BRIEF DESCRIPTION OF THE DRAWINGS

In the following drawings like reference numbers are used to refer to like elements. Although the following figures depict various examples, the one or more implementations are not limited to the examples depicted in the figures.

FIG. 1 illustrates an example cinema environment having a surround sound speaker array powered by multiple power amplifiers as presently known.

FIG. 2A illustrates a cinema environment having a surround sound speaker array powered by a multi-channel power amplifier.

FIG. 2B shows two or more amplifiers connected together to form a master/slave configuration.

FIG. 3 is a block diagram illustrating main functional components of a multi-channel amplifier.

FIG. 4A illustrates the generation of per-channel gain levels based on certain amplifier operating characteristics.

FIG. 4B illustrates calculation of per-channel and global gain values to determine audio output levels for the speaker feeds.

FIG. 5 illustrates a multi-channel amplifier operating in a rendering environment with lighting control.

FIG. 6 is a perspective view of a multi-channel amplifier module.

FIG. 7 illustrates components of an amplifier and airflow through the amplifier for thermal management.

FIG. 8 illustrates a circuit for amplifier thermal management.

FIG. 9 illustrates an example temperature profile curve for a multi-channel amplifier.

FIG. 10 illustrates a multi-channel amplifier with a front-end FPGA processing the input digital audio stream, under some embodiments.

FIG. 11A is a block diagram of an FPGA stage of a multi-channel amplifier, under some embodiments.

FIG. 11B is a block diagram of a Class-D modulator stage with a loop bandwidth modulation circuit, under some embodiments.

FIG. 11C is a detailed diagram of an integrator circuit for the Class-D modulator stage of FIG. 11B, under an embodiment.

FIG. 12 illustrates a multi-FPGA system for a Class-D modulator for a multi-channel amplifier. monitoring circuit for a continuous-time Class-D modulator.

FIG. 14 illustrates example waveforms for the PWM pulse length measurement performed by the PWM circuit of FIG. 13.

FIG. 15 illustrates a gain control module that can be implemented in the programmable logic of the Class-D modulator circuit of FIG. 11A.

FIG. 16 illustrates example waveforms for duty limiting and channel functions performed by the gain control circuit of FIG. 15.

FIG. 17 illustrates a power detection module for use with a Class-D modulator circuit.

FIG. 18 illustrates an FPGA-based circuit that monitors the current and voltage levels for audio signals input to a speaker.

FIG. 19 illustrates example waveforms for calculating the impedance of a speaker using current-voltage characteristic curves.

FIG. 20 illustrates a circuit monitoring gate drive characteristics using programmable dead-band timing.

FIG. 21 illustrates a diagram of the integrator circuit for the output stage of FIG. 11B, in which a transconductance amplifier is used as the variable current circuit of FIG. 11C.

FIG. 22 is a block diagram of the Class-D modulator stage of FIG. 11B with a loop bandwidth modulation circuit and high frequency detection and termination tuned circuit.

FIG. 23 illustrates an LCR termination circuit of FIG. 22 in a series configuration.

FIG. 24 illustrates an LCR termination circuit of FIG. 22 in a high-pass filter configuration.

FIG. 25 illustrates a high-frequency detection circuit for the termination circuit of FIG. 24.

FIG. 26 illustrates example plots of frequency versus gain and phase for tuned termination circuit.

DETAILED DESCRIPTION

Systems and methods are described for an integrated cinema amplifier having a power supply stage that distributes power over a plurality of channels for rendering immersive audio content in a surround sound listening environment. The amplifier automatically detects maximum and net power availability and requirements based on audio content by decoding audio metadata and dynamically adjusts gains to each channel or sets of channels based on content and operational/environmental conditions. The amplifier monitors certain operational and environmental characteristics (e.g., temperature, voltage/current flow, load consumption, power supply condition, speaker health, and the like) and adjusts channel gains based on load and/or fault conditions. It also includes an interface to a renderer and can adjust channel gains based on audio content. It may also include a closed-loop synchronization circuit to ensure that channels are clocked and switched at the same time to mitigate noise, beats, and other distortion.

Aspects of the one or more embodiments described herein may be implemented in an audio or audio-visual (AV) system that processes source audio information in a mixing, rendering and playback system that includes one or more computers or processing devices executing software instructions. Any of the described embodiments may be used alone or together with one another in any combination. Although various embodiments may have been motivated by various deficiencies with the prior art, which may be discussed or alluded to in one or more places in the specification, the embodiments do not necessarily address any of these deficiencies. In other words, different embodiments may address different deficiencies that may be discussed in the specification. Some embodiments may only partially address some deficiencies or just one deficiency that may be discussed in the specification, and some embodiments may not address any of these deficiencies.

For purposes of the present description, the following terms have the associated meanings: the term "channel" means an audio signal plus metadata in which the position is coded as a channel identifier, e.g., left-front or right-top surround; "channel-based audio" is audio formatted for playback through a pre-defined set of speaker zones with associated nominal locations, for example, 5.1, 7.1, and so on (i.e., a collection of channels as just defined); the term "object" means one or more audio channels with a parametric source description, such as apparent source position (e.g., 3D coordinates), apparent source width, etc.; "object-based audio" means a collection of objects as just defined; and "immersive audio," (alternately "spatial audio" or "adaptive audio") means channel-based and object or object-based audio signals plus metadata that renders the audio signals based on the playback environment using an audio stream plus metadata in which the position is coded as a 3D position in space; and "listening environment" means any open, partially enclosed, or fully enclosed area, such as a room that can be used for playback of audio content alone or with video or other content, and can be embodied in a home, cinema, theater, auditorium, studio, game console, and the like.

Embodiments are directed to a sound processing and amplification system that is configured to work with a sound format and processing system that may be referred to as an immersive audio system that is based on an audio format and rendering technology to allow enhanced audience immersion, greater artistic control, and system flexibility and scalability. Such a system generally comprises an audio encoding, distribution, and decoding system configured to generate one or more bitstreams containing both conventional channel-based audio and object-based audio. An example of an adaptive audio system that may be used in conjunction with present embodiments is described in U.S. Provisional Patent Application 61/636,429, filed on April 20, 2012 and entitled "System and Method for Adaptive Audio Signal Generation, Coding and Rendering."

An example immersive audio system and associated audio format is the Dolby Atmos platform. Such a system incorporates a height (up/down) dimension that may be implemented as a 9.1 surround system, or similar surround sound configuration (e.g., 11.1, 13.1, 19.4, etc.). A 9.1 surround system may comprise composed five speakers in the floor plane and four speakers in the height plane. In general, these speakers may be used to produce sound that is designed to emanate from any position more or less accurately within the listening environment. Though immersive audio (such as Atmos) may have been originally developed for movie programs played in cinema environments, it has been well adapted for home audio and smaller venue applications. Embodiments are generally described with reference to cinema or large theatre applications, but should be understood to apply equally well to home or smaller scale applications as well.

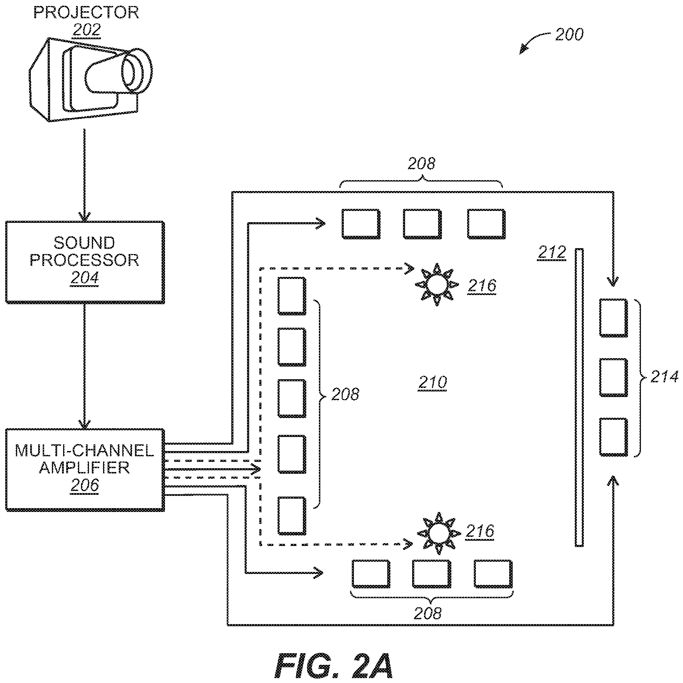

FIG. 2A illustrates a cinema environment having a surround sound speaker array powered by a multi-channel power amplifier under some embodiments. As shown in FIG. 2A, a cinema or similar audio/visual (A/V) listening environment 210 has an array of speakers 208 and 214 placed around screen 212 and the listening environment in any appropriate surround sound arrangement (e.g., 5.1, 7.1, 9.1, etc.). The audio content is provided by projector 202 through a sound processor 204 and then to a multi-channel amplifier 206. Multi-channel amplifier 206 drives the speakers 208 and 214 through individual speaker feeds, and in contrast to the array of multiple individual amplifiers 106 shown in FIG. 1, it is a single unitary amplifier unit. In an embodiment, it is provided as a single component occupying just one-half height rack (19" rack mount) when installed in an A/V booth of a cinema.

In an embodiment, amplifier 206 also includes circuitry (not shown) to power the main theatre lights 216 and optional mood or ambient lights (not shown) that may be placed throughout the theatre. This power can be transmitted over the speaker wires, and the lights may be standard theatre lighting or specially designed modules, such as multi-colored LED arrays (or similar energy efficient, electronically controlled, multi-colored lighting device) placed in appropriate locations of the listening area 210. In an alternative embodiment, the lights can be integrated in at least some of the speaker cabinets (not shown).

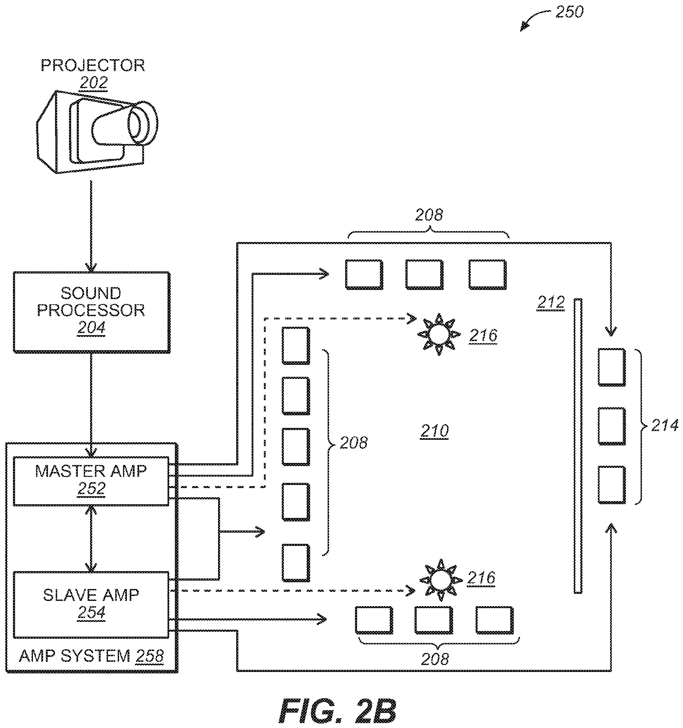

For the illustration of FIG. 2A, the amplifier 206 may be a single unitary amplifier. FIG. 2B shows an alternative embodiment in which two or more amplifiers may be connected together in a serial or daisy-chain fashion so that an amplifier system is formed having a master/slave configuration. FIG. 2B illustrates the system of FIG. 2A in which an amplifier system 258 comprises two amplifiers 252 and 254 coupled together serially to form a master/slave amp system in which the two amplifiers work together to power different speakers and or lights of the listening environment 210, or in which they provide increased power capacity for the entire system (e.g., 600w together instead of 300w for a single amp), or redundancy functions in case of a failure or fault conditions. The amplifiers 252 and 254 may be connected over an AES67 interface or similar amplifier interface. For the embodiment of FIG. 2B, the master/slave amps are configured such that one amp 252 drives the lights and speakers on one side of the cinema 210, while the other amp 254 drives the lights and speakers on the other side of the cinema. Many other configurations are also possible such as having one amp drive only the lights or only the speakers, or having one amp drive the passive speakers (e.g., the surround speakers 208) and the other amp drive the powered speakers (e.g., the behind screen speakers 214), or having different amps drive different sets of interleaved speakers, etc. In an embodiment, the number of channels is increased by each individual amplifier, such as 2x24 channels for a total of 48 channels for two amps in amp system 258. Alternatively, the master/slave amps may be configured such that number of channels remains the same, but the power overhead for each channel increases through the additional amplifier, or any other similar combination of channel and/or power overhead increase.

Although illustrations of FIG. 2B are shown with two amps 252 and 254, it should be noted that any practical number of amplifiers may be provided with a single master amp or amp array driving one or more slave amps.

For an embodiment in which an analog amplifier may be available to power the speakers, such as an older cinema installation, the amp system may be coupled to the analog amp through a digital-audio-converter (DAC) to convert the digital signals from the renderer or sound processor 204 into the requisite analog signals for the analog amp.

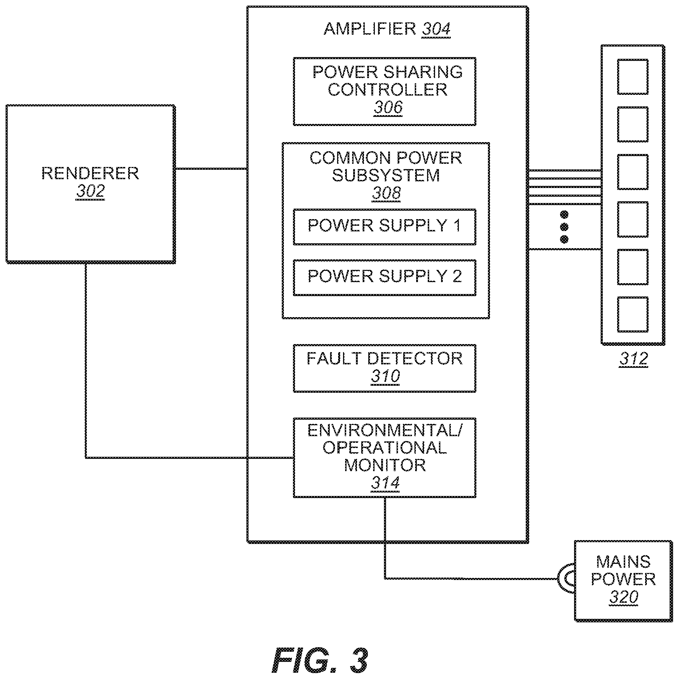

FIG. 3 is a block diagram illustrating main functional components of a multi-channel amplifier, under some embodiments. For the system of FIG. 3, audio signals from renderer 302 are amplified in amplifier 304 and transmitted to speaker array 312.

In an embodiment, the speakers 312 of FIG. 3 are configured and placed to playback immersive audio content in which audio signals being presented to the listener originate from in front of and around the listening position in the horizontal plane (main speakers) and overhead plane (height speakers). A full loudspeaker system layout may consist of: front loudspeakers (e.g., Left, Center, Right, and optionally Left Center Right Center, Left Screen, Right Screen, Left Wide, and Right Wide), Surround loudspeakers (e.g.,: Left Surround, Right Surround, and optionally Left Surround 1, Right Surround 1, Left Surround 2, Right Surround 2), surround back loudspeakers (e.g., Left Rear Surround, Right Rear Surround, Center Surround, and optionally Left Rear Surround 1, Right Rear Surround 1, Left Rear Surround 2, Right Rear Surround 2, Left Center Surround, Right Center Surround), height loudspeakers (e.g., Left Front Height, Right Front Height, Left Top Front, Right Top Front, Left Top Middle, Right Top Middle, Left Top Rear, Right Top Rear, Left Rear Height, Right Rear Height), and subwoofer speakers. This represents one example of a speaker configuration, and other configurations are also possible.

Component 302 generally represents an audio component that is generally referred to as a "renderer." Such a renderer may include or be coupled to a codec decoder that receives audio signals from a source, decodes the signals and transmits them to an output stage that generates speaker feeds to be transmitted to individual speakers in the room. In an immersive audio system, the channels are sent directly to their associated speakers or down-mixed to an existing speaker set, and audio objects are rendered by the decoder in a flexible manner. Thus, the rendering function may include aspects of audio decoding, and unless stated otherwise, the terms "renderer" and "decoder" may both be used to refer to an immersive audio renderer 302, such as shown in FIG. 3, and in general, the term "renderer" refers to a component that transmits speaker feeds to the speakers, which may or may not have been decoded upstream. In an embodiment, the AVR or renderer/decoder 305 of FIG. 3 comprises an audio/video receiver for use in home entertainment environments (home theater, home television, etc.). The AVR generally perform multiple functions. First, it provides a connection point for multiple source devices, and the AVR is responsible for switching among the inputs, and second, it performs audio decoding and processing (e.g., surround sound processing, Dolby Pro Logic™ processing, Dolby Digital™ processing, Dolby TrueHD™ processing, etc.). It may also provide amplification or pre-amplification for speakers. For the embodiment of FIG. 3, the amplification to drive the speakers 312 is provided by power amplifier 304.

In an embodiment, amplifier 302 is a multi-channel, Class-D amplifier that comprises main functional components of a power sharing controller 306, a power subsystem 308, and a fault detector 310. An environmental/operational monitor 314 may be provided as part of the amplifier or as a separate component that provides certain operating and environmental condition data to the amplifier. Amplifier 314 is preferably packaged in a single housing to provide a unitary component that works with a compatible renderer or sound process with respect to providing a number of separate channels (e.g., 24 channels) for playback of immersive audio content.

In an example, the amplifier 304 provides power sharing or power steering of the common power subsystem 308 across all of the channels of a multi-channel speaker output stage. In an example configuration, up to 24 channels may be supported, but other possible embodiments are not so limited. The power subsystem (or "power supply stage") 308 may utilize two redundant power supplies (e.g., connected in series or parallel), though other single or multi-power supply configurations are also possible. The power supplies are redundant in that failure of one supply will cause the other supply to kick in and provide power to the amplifier. The fault detector 310 monitors the status of the power subsystem 308 and detects the health of the power supplies. It is configured to shut down a failing supply if an error is detected and utilize the remaining power supply to power the unit. In an embodiment, the power supplies may be configured to run in parallel so that either supply can provide full power, or they can be run in parallel with each supply providing half the power. In this case, failure of one supply may cause audio to play at half the available power (e.g., 41V instead of a full 82V), but this prevents the condition where no audio is available in the case of a power failure.

In an example, the power supply stage may comprise a plurality of individual power supplies configured in a multiple phase architecture, where the different power supplies are designed to operate with different phase angles and sum into a unified output. This embodiment uses multiple power supplies at different phase angles that are then summed at the outputs to form a singular output. This technique improves power conversion efficiency, evenly distributes thermal dissipation, and allows redundancy within the power supply stage.

In an example, the internal or external environmental/operational monitor 314 periodically samples the audio performance of the theatre or cinema 210 on a regular basis and detects and predicts speaker issues, such as a drop in performance, a blown speaker or one that has introduced rub/buzz. The amplifier is configured to shut that channel down and notify the renderer 302 to re-render the content, mapping out that faulty speaker and use the other speakers to compensate for the failed or missing speaker. It can also detect non-speaker performance issues, such as rub and buzz, in a fixture or tile in the theatre. This information may be accommodated through re-rendering, or it can be reported to system administrators or personnel.

In an example, the power supply is designed to allow the system to operate from a normal 120VAC 20Amp service without blowing the AC mains circuit breaker. To this end, feedback from the power supply shall be available from the power supply to signal the system that the maximum output is being reached so as not to allow the amplifier to scale-back processing to eliminate an over current condition on the mains supply. The amplifier is also configured to operate a wide range of possible supply voltages based on country of use or local power supply variations. For example, mains power can vary from a low of 100V in Japan to a high of 240V in Australia. The setting of 240V at 20 amps thus represents the maximum power that the amp can deliver without tripping any circuit breakers in an installation, and this maximum power output is tailored for each different installation. The monitor 314 and controller 306 components provide the maximum power delivered based on the input power available.

As shown in FIG. 3, the monitor component 314 is coupled to the mains power 320, which represents a circuit breaker and power junction to the cinema or building power supply. Through this component, the amplifier is configured to detect the power supply levels provided by the mains power and to adjust the power delivered to the speakers 312 accordingly. The range of mains power can vary depending on country, or facility configuration (such as in buildings with selectable voltages), and the amplifier can be configured to accommodate a wide range of AC voltages, such as between 85-265 VAC at any appropriate phase and current. Maximum power levels can be programmed into the amplifier through user input using known supply ratings and circuit breaker ratings, such as may be provided during a configuration or installation operation. Alternatively, these values can be determined dynamically by the use of test signals and test voltages such as to deliberately reset/set the breaker to determine maximum voltage levels, or by reading relevant parameters from enabled intelligent power supply devices.

The power supply is designed to allow the system to operate from a normal (e.g., 120VAC 20Amp) service without blowing the AC mains circuit breaker. Feedback from the power supply is made available from the power supply to signal the system that the maximum output is being reached so as not to allow the amplifier to scale back processing to eliminate an over-current condition on the mains supply. Certain control signals are made available to the system controller 306 for this purpose, such as 95% power level reached, power fail indication, and power good.

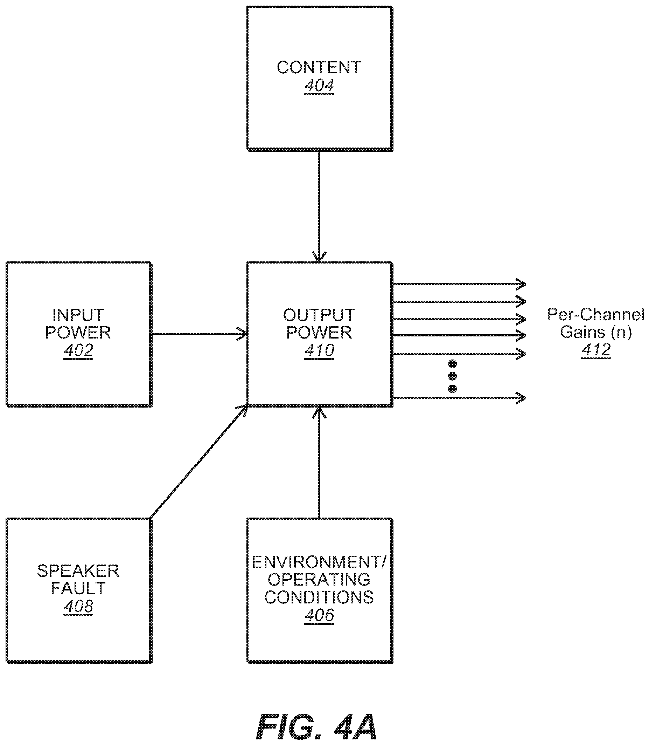

In an example, amplifier 304 manages the gain of each individual channel based on certain environmental and operating conditions, as monitored by the fault detector 310 and environmental/operational monitor 314. FIG. 4A illustrates the generation of per-channel gain levels based on certain amplifier operating characteristics, under some embodiments. As shown in FIG. 4A, the per-channel gains 412 are derived from the output power 410 provided by the amp on each of the channels 1-n, where n is any appropriate number of channels, such as provided by the renderer 302. In an example embodiment in which the renderer corresponds to a Dolby Atmos Cinema Processor (CP850) or similar renderer, 24 audio channels are output from the renderer and amplified individually by amplifier 304. The output power 402 is a function of several inputs including the input power 402, the audio content 404 and the environmental/operational conditions 406. As described above, the input power 402 comprises the AC mains power voltage 320 and the current delivery and circuit breaker threshold. These values can be sensed by the amplifier and/or input into the amp by technician as part of amplifier installation and setup process. The input power 402 dictates the maximum amount of output power 410 that can be provided, and hence the maximum per-channel gain values 412 that are available to each of the channels individually and collectively. As also described above, the per-channel gains can also be set or modified depending on any speaker fault conditions detected by the fault detector 310. In the case of any failing or failed speakers, speaker cables, output stage, or any other specific channel component, power to that channel may be attenuated or cut and other channels boosted accordingly to compensate.

For the example, of FIG. 4A, the audio content 404 can also be used to determine the output power 410 for each channel. In this embodiment, the renderer provides appropriate data to the amp, such as through immersive audio metadata that is used by the amplifier to adjust the per-channel gains 412 accordingly. For example, certain center or front channels may be amplified greater than surround channels if the audio is primarily dialog rather than music. Such content-dependent gain control can be useful in certain suboptimal conditions, such as when the input power 402 is low so that instead of playing dialog at the same level as music or background audio at equally low levels, the dialog can be enhanced at the expense of the music to make it relatively more intelligible. The amplifier and renderer may be configured to communicate and generate speaker feeds according to a defined time-shift so that the amplifier can adequately process the audio content data and set the gain levels accordingly. For example, the renderer can send content data to the amplifier milliseconds ahead of the actual playback of the signals so that the amplifier has time to set the gain levels prior to sending the speaker feeds to the speakers.

In an example, the monitor component 314 (of FIG. 3) monitors the mains power to provide an indication of any change of input power 402 to the amplifier. Any significant change may necessitate a change in the per-channel gains, such as a decrease in power requiring attenuation of certain channels, and an increase in power allowing for increasing the gain across all channels. The monitor 314 can also monitor other external conditions, such as ambient temperature in the control room or amplifier enclosure so that in a potential overheating situation or dangerous environmental condition, the output power 410 can be reduced or cut to prevent system failure. The operating conditions 406 represent certain internal amplifier conditions, such as current flow to the speakers, temperature on a per-channel basis, power supply health, temperature (thermals or thermal conditions) for the power supplies, load consumption on the speaker feeds, and certain Class-D control loop (modulation monitor) conditions. The amplifier is generally configured to provide full voltage and current on every channel depending on the input power 402 and other optional characteristics such as the content 404 and speaker health 408. In the event of any abnormal internal operating conditions, the output power can be adjusted to compensate for any problems or potential faults. For example, if the power supply thermal temperature is too high or if the speaker loads are too high, power can be cut.

In an example, the power sharing controller 304 of FIG. 3 can be configured or programmed to reduce the gain values by certain defined amounts depending on the compromised or negative condition detected by either fault detector 310, monitor 314, or on the basis of changed audio content from the renderer 302. For example, the per-channel gain for any particular channel or channels can be successively cut by -3dB until the fault or problem condition is alleviated. Internal feedback loops within the amplifier update the controller with respect to changed operating conditions in response to the changed per-channel gains. For example, in a power supply overheating situation, the controller may cut the gains across all channels until the monitor 314 detects stabilization in the thermal condition. Likewise, if a brownout condition is detected in which mains power is significantly decreased, the gains may be cut until full power is restored, at which time, the controller may re-elevate the gains to their original levels.

The amplifier may also be programmed to implement specific channel shutdown or switchover procedures in the event of serious problems, such as failure of speakers or input power degradation (e.g., a brownout or black-out condition). In such a case, for example, heavily loaded channels may be shut down and all available sound sent to one or a few low power speakers.

The output gains 412 can be set equally for all channels, or individually so that each channel or certain sets of channels have different gain values. In this manner, the per-channel gains can be adjusted to form a hierarchy or prioritized sets of gains. This allows the gains to be increased or decreased based on relevant characteristics such as content in relation to input power, potential failure conditions of speakers or power supply components, speaker loads, current draw, and so on. The order of priority dictates the relative amount of gain assigned on a per-channel basis for each level of priority. For example, with reference to FIG. 2A or 2B, speakers 214 may be assigned priority 1, the rear bank of surround speakers 208 may be assigned priority 2, the L/R banks of surround speakers 208 may be assigned priority 3, and the LFE may be assigned priority 4. In this case, the priority 1 speakers may be the last speakers to be attenuated in case of adverse environmental or operating conditions, while the LFE and side surround speakers would be the first channels to be attenuated or cut. As should be noted, any grouping of channels and desired priority levels may be assigned depending on the capabilities and constraints of the playback system.

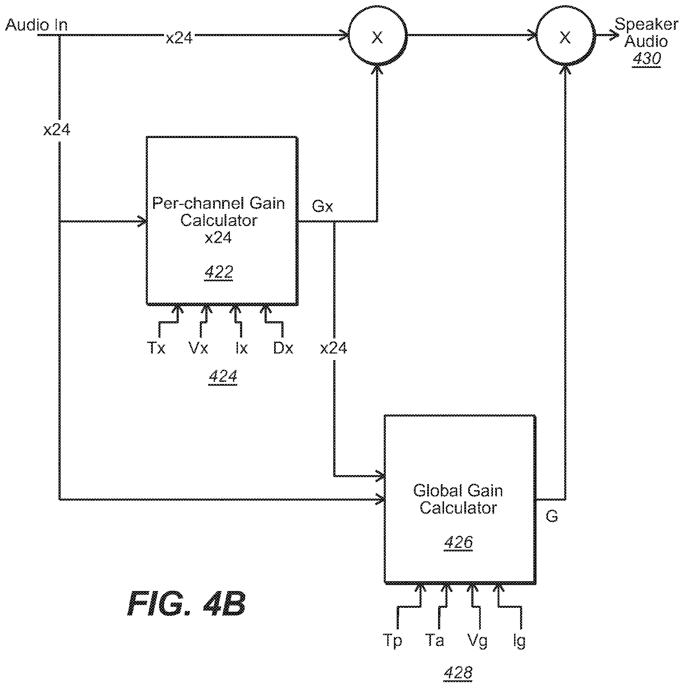

In an example, the per-channel gain values applied to the channels of the output audio comprise per-channel gains and global (system) gains. FIG. 4B illustrates calculation of per-channel and global gain values to determine audio output levels for the speaker feeds, under some embodiments. As shown in FIG. 4B, the input audio channels (e.g., 24 channels, though other numbers of channels are also possible) are input to a per-channel gain calculator 422 for the *n* channels and a global gain calculator 426 for the *n* channels. The per-channel gain calculator receives input parameters 424 from one or more sensors or components within the amplifier and listening environment, such as the fault detector 310 and monitor 314. For the embodiment shown, these input parameters 424 include: Tx, the per-channel amplification stage temperature; Vx, the per-channel voltage, Ix, the per-channel current; and Dx, the PWM duty cycle. The calculated per-channel gains Gx are then input to the global gain calculator 426 along with the audio input signal. The global gain calculator 426 receives input parameters 428 from the appropriate sensors and components. For the embodiment shown, these input parameters 424 include: Tp, the power-stage temperature; Ta, the ambient temperature; Vg, total voltage; and Ig, the total current. The input parameters 424 and 426 represent an example set of characteristics and other similar and appropriate parameters may be used depending on application, content, and environmental conditions.

As shown in FIG. 4B, the per-channel gain values Gx are combined with and applied to each corresponding channel of the audio input signal. The global gain value G from calculator 426 is then applied to the audio signal after the per-channel gains are applied to produce the speaker output channel feeds 430.

In an example, gain adjustments are made according to the following algorithm (where Pr is the recommended power):

Gain adjustments:

If (Ig\*Vg > Pr) then global gain (G) can be reduced until Ig\*Vg <= Pr

- This can also be done by analyzing the content and dropping Gx for the channels with high peaks.
- Can also do both, i.e., dropping the per-channel gain on high-peak channels by a predefined acceptable amount and then dropping the overall gain until Pr Ta has inverse relation to G. There is a longer time constant to measure and act on this. Tp has an inverse relation on Pr; for example, the higher the temperature, the lower recommended power usage will be for the system.

For example, Ix\*Vx (channel power) cannot exceed per-channel recommended power (Prx) and the gain (Gx) will be reduced until it does.

Tx has an inverse relation to the per-channel recommended power (Prx).

Dx may be an on/off switch for the channel.

The global gain G represents the power distribution for the system and takes into account ambient and amplifier temperatures and total voltage and current values. The per-channel gains take into account individual channel voltages, currents, and temperatures, as well as the PWM (pulse width modulated) duty cycles. In an embodiment, the power controller adjusts the per-channel gain values based on per-channel characteristics, power distribution characteristics, speaker health characteristics, and mains power supply characteristics.

With regard to speaker health monitoring, the Vx and Ix parameters can be used to provide the frequency response of a speaker (using Fourier transforms) and can help gauge the health of individual drivers. This is done by measuring impedance (Z = V/I) and verifying that it matches the expected curve for the speaker. A system can flag the speaker as "broken" for re-rendering or transmit a user alert, and/or turn off that speaker. Any alert or flag can then be transmitted to a system administrator, theatre staff or NOC (Network Operations Center) for further action. This signal can also be generated for non-speaker performance issues, such as rub and buzz, in a fixture or tile in the theatre.

Lighting Control

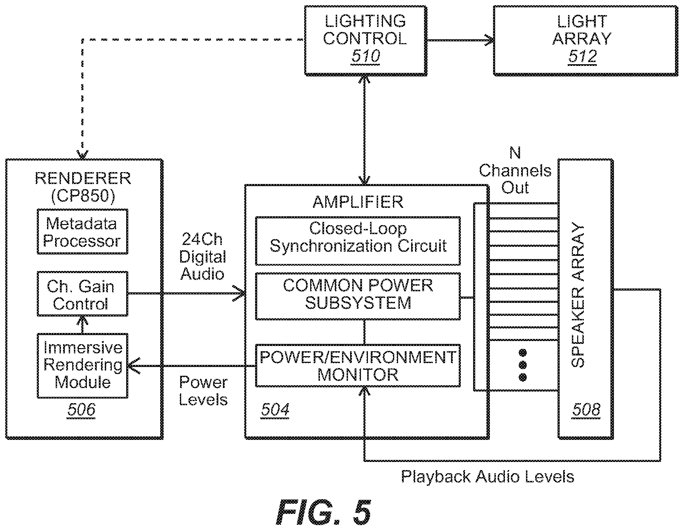

FIG. 5 illustrates a multi-channel amplifier operating in a rendering environment with lighting control, under some embodiments. As stated above, in an embodiment, the amplifier 504 is configured to work in conjunction with a compatible renderer 502 that provides the audio signals over the same number of channels (speaker feeds) output by the amplifier. Such a renderer may be a Dolby CP850 cinema processor, or similar sound processor. This renderer plays back traditional 5.1 and 7.1 surround sound formats, as well as immersive audio content such as Dolby Atmos, which comprises audio objects and beds (channel-based audio). In general, audio objects can be considered as groups of sound elements that may be perceived to emanate from a particular physical location or locations in the listening environment. Such objects can be static (stationary) or dynamic (moving). Audio objects are controlled by metadata that defines the position of the sound at a given point in time, along with other functions. When objects are played back, they are rendered according to the positional metadata using the speakers that are present, rather than necessarily being output to a predefined channel. In an immersive audio decoder, the channels are sent directly to their associated speakers or down-mixed to an existing speaker set, and audio objects are rendered by the decoder in a flexible manner. The parametric source description associated with each object, such as a positional trajectory in 3D space, is taken as an input along with the number and position of speakers connected to the decoder. The renderer utilizes certain algorithms to distribute the audio associated with each object across the attached set of speakers. The authored spatial intent of each object is thus optimally presented over the specific speaker configuration that is present in the listening environment.

For the example, of FIG. 5, the renderer 506 comprises an immersive audio rendering module and channel gain control to transmit the appropriate digital audio signals to the amplifier 504. A metadata processor processes the corresponding parametric position/location/trajectory data for audio objects to generate the N-channel speaker feeds to the amplifier 504. The amplifier 504 includes a common power subsystem that provides power to all channels of speaker array 508, and sets the per-channel gain values based on the audio content and input from a monitor component that monitors power, environmental and operating conditions. The amplifier 504 may also include a closed-loop synchronization circuit to ensure that channels are clocked and switched at the same time to mitigate noise, beats, and other distortion.

In an embodiment, the amplifier also includes or is coupled to a lighting control unit 510 that uses the amplifiers power subsystem to power the lights 512 of the listening environment (e.g., cinema or theatre). The light array 512 may be any appropriate light or set of lights within the cinema, and may include direct (ceiling/wall) lights, ambient lights, floor path lights, seat lights, and the like. The lights may also be integrated into the speaker. The lights 512 may be coupled to the controller 510 through wired or wireless transmission means.

Metadata from the renderer 502 is received by the amplifier 504 and used to change the lights based on the content generated by the renderer. The metadata may include definitions that dictate light levels (color/intensity), or it may be standard immersive audio metadata that is interpreted by the lighting control unit 510 to generate the appropriate lighting signals to light array 512. The lighting control unit uses the metadata to automate and enhance the ambience of the listening environment. In an embodiment, the light array comprises ambient lights, while the main cinema lights are controlled separately, such as by the cinema operator. The ambient lights may be RGB LEDs that change color based on metadata from the exhibitors to enhance the content marketing, mood of the environment, or augment the audio by providing lighting cues in sync with the audio. The lighting intensity and colors can be changed based on the events of the showing, such as pre-show, intermission, and post-show. For example, the ambient color can be changed to that of the cinema brand or sponsor during these periods when the movie is not playing. The lighting can be synchronized to any music or messages playing in the background, as well. Using the common power subsystem of the amplifier, power is split between the speakers and the lights, so that during a light control period, power to the speakers may be reduced to accommodate powering the lights. Thus, when the ambient or main lights are on, most of the power delivered can be to the lights, and as the lights fade in preparation for pre-show trailers, power is shared and/or switched in the amplifier/speakers from lights to the audio. Light and audio power can be provided using the same two speaker wires, which helps greatly reduce the cost of installation, as separate power lines do not need to be run to the lights. It also greatly enhances automation, as metadata for the audio content can also be used to control the lights, thus ensuring synchronization between lights and sound, and balanced power distribution between the light and speaker feeds.

Besides lights, other actuators can be controlled by the amplifier in sync with the audio content using the metadata that is either generated by the renderer or is transferred in the content. These include steam generators, water sprinklers, fans, smell/aroma generators, prop movements, LCD displays, holograms, and so on. Such actuators may be used when the amplifier is deployed in applications such as theme parks, simulators, and industrial/military installations.

Thermal Management

In an example, the amplifier includes a thermal management system that consists of arrays of main and auxiliary fans, and temperature sensors across all channels, power supplies, and the chassis. Sensor outputs are collected, analyzed and fed back to a thermal controller which controls fan speed across the system. Included in this system is a predictive temperature control apparatus design to adjust future thermal profiles based on known or established environmental behaviors. For example, an adjustment can be made when a predicted temperature profile looks to be ramped beyond a set limit.

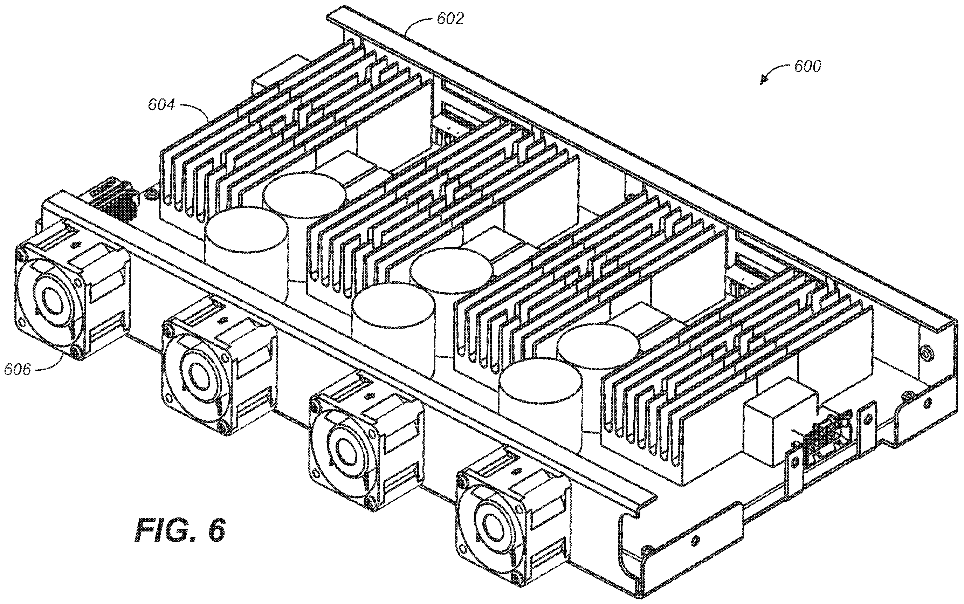

FIG. 6 is one possible example embodiment of a multi-channel amplifier module shown in a perspective view. As shown in FIG. 6 an amplifier module 600 includes a unitary chassis 602 which holds a plurality of individual amplifier circuits which further includes a plurality of finned heatsinks 604 (e.g., this non-limiting example includes four) for dissipation of heat. Also, FIG. 6 shows a plurality of fans 606 (e.g., this non-limiting example includes four) may be provided at appropriate locations of the chassis to drive air over and through the amplifier circuits out through vents in the chassis 602. Any appropriate number, size, and power of fans, and heat sinks may be used depending on the configuration and power output of the amplifier circuits and overall amplifier module 600.

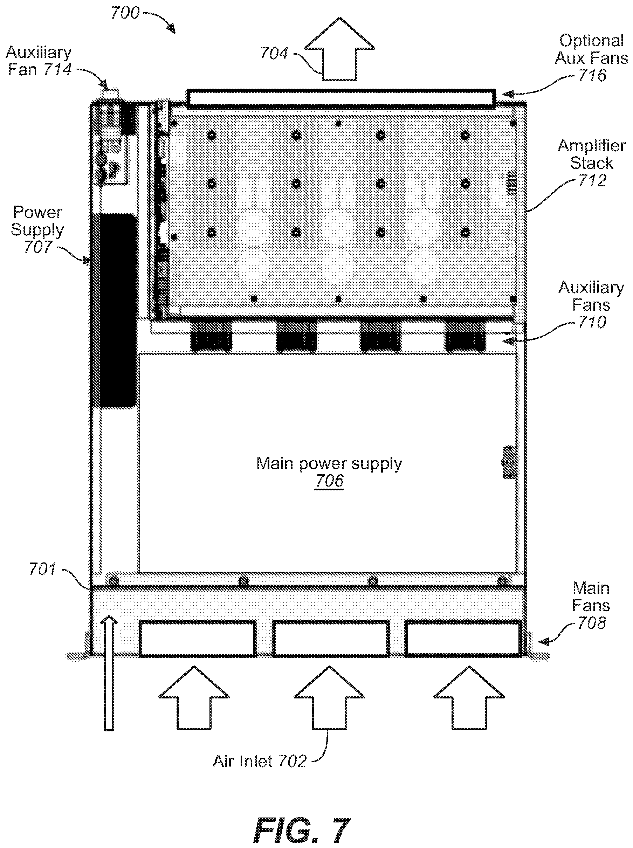

FIG. 7 illustrates components of an amplifier and airflow through the amplifier for thermal management, under some embodiments. As shown in FIG. 7, amplifier 700 includes an amplifier stack 712 (e.g., corresponding to amplifier module 600 in FIG. 6), a main power supply 706 and other power supplies 707. A mounting chassis 701 encloses these main components and provides a structure for mounting in a rack or other installation, as well as routing passages for air flow through the amplifier. Air flows in through air inlet 702 as drawn in by main fans 708 to flow over the main and other power supplies 706, 707. Auxiliary fans 710 (e.g., corresponding to fans 606 in FIG. 6) help drive the air over the amplifier stack 712 to vent out 704 through the front (and/or sides or other surfaces) of the amplifier. One or more sets of auxiliary or additional fans 714 and 716 may be provided to draw or drive air over other components or areas of the amplifier. The configuration of air vents, fans, and components for amplifier 700 are provided for purposes of illustration of possible embodiments, and other configurations are also possible.

In general, the thermal management system of the multi-channel amplifier 600 comprises speed control of the fans. The main, auxiliary and other fans may each be variable speed fans whose speed is controlled by a controller that monitors the thermal characteristics of the amplifier, which may include per-channel temperatures, power supply temperatures, internal chassis temperature, ambient temperature, and any other relevant temperatures. The fans may be set to operate at a default or minimum speed, and then increased to provide greater cooling if the sensors indicate that one or more of the relevant temperatures increases above a defined limit. Once the temperature or temperatures comprising the thermal profile is within a safe operating range, the speed of the fans may be decreased to minimize power consumption and reduce operating noise and vibration.

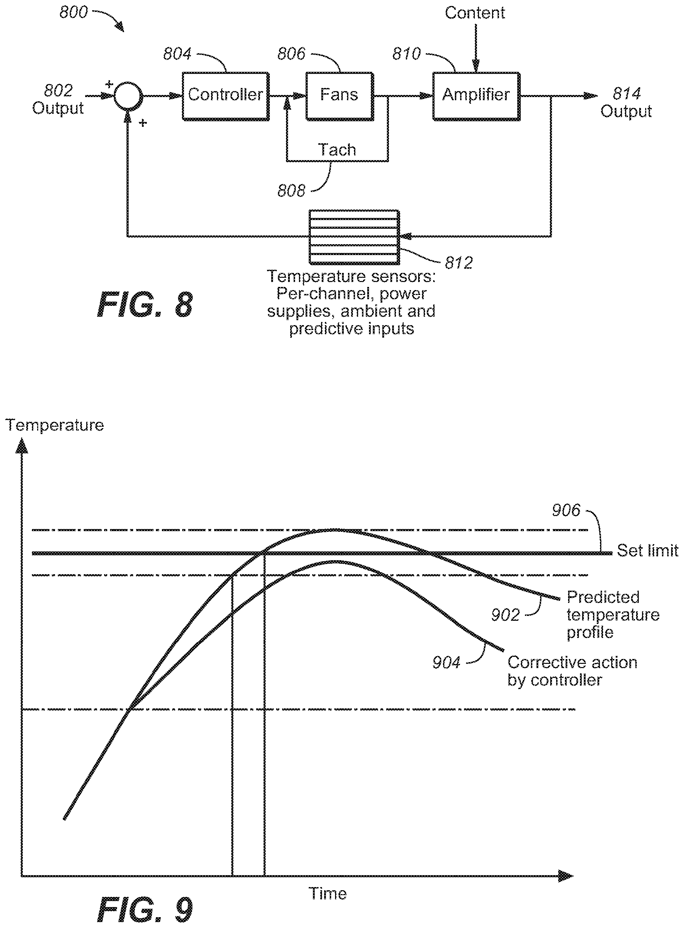

FIG. 8 illustrates a circuit for amplifier thermal management, under some embodiments. As shown in FIG. 8, circuit 800 receives audio input 802, which is summed with a feedback signal from a number of temperature sensors 812. The sensors are located and configured to sense the relevant temperatures comprising the thermal profile of the amplifier, such as per-channel temperature, power supply temperature, ambient temperature, and any predictive inputs. The signal is then passed to a controller unit 804, which is coupled to the fans 806. The fans are controlled by one or more tachometers 808 for speed control over individual fans or arrays of fans within the amplifier. The audio content is then transmitted through amplifier stage 810 to form the audio output 814. The audio output comprises the individual channels (e.g., 24 channels) of the amplifier, which also provide the input to at least some of the sensors 812.

As shown in FIG. 8, a predictive temperature control component may be used to adjust future thermal profiles based on known or established environmental behaviors. For example, an adjustment can be made when a temperature profile is predicted to increase beyond a set limit. FIG. 9 illustrates an example temperature profile curve for a multi-channel amplifier, under some embodiments. The plot of FIG. shows a relevant temperature measurement of the amplifier over time. A limit 906 is defined at a set temperature to define the highest acceptable operating temperature of the amplifier. A measured or predicted temperature profile 902 plots the temperature as it rises and falls over time. If the controller 804 determines, predicts or is provided sensor data that indicates that the temperature profile plot will or has exceeded the set limit 906, the fans are actuated or accelerated to lower the temperature so that it remains below the limit. This fan control constitutes the corrective action performed by the controller and yields the corrective temperature profile 904. In this manner, the thermal conditions of the amplifier can be controlled. FIG. 9 may represent an overall internal temperature of the amplifier or it may represent any one of the relevant temperatures comprising the thermal profile, i.e., individual channel temperature, power supply temperature, ambient temperature, etc.

Class-D Modulator

In an embodiment, the multi-channel amplifier includes a continuous time Class-D modulator with an embedded programmable logic device, such as through a Field Programmable Gate Array (FPGA) device. For this embodiment, amplifier 304 in FIG. 3 includes an embedded FPGA device in the forward path. The FPGA is configured to provide several processing benefits, including: (A) synchronization control, the FPGA derives a synchronization clock for the modulator and can monitor 1-bit PWM for sync-lock status; (B) the FPGA monitors the PWM duty cycle to detect overage conditions and subsequently lowers audio levels to eliminate hard-clipping events; (C) the FPGA provides precision implementation of dead-band timing for subsequent output stage; (D) the FPGA can dynamically control the net loop delay seen by the 1-bit PWM using programmable delay lines; (E) the FPGA monitors the amplifier output conditions (e.g., voltage & current) to provide comparison with the 1-bit PWM and/or determine load characteristics; (F) the FPGA monitors and/or controls the front-end integrator/s to trim the hardware for optimal distortion (THD+N), and so on. Although embodiments are described for an FPGA device that performs these and other functions, it should be noted that any other programmable logic device (PLD), gate array, or even hardwired circuit or software executing component may be used.

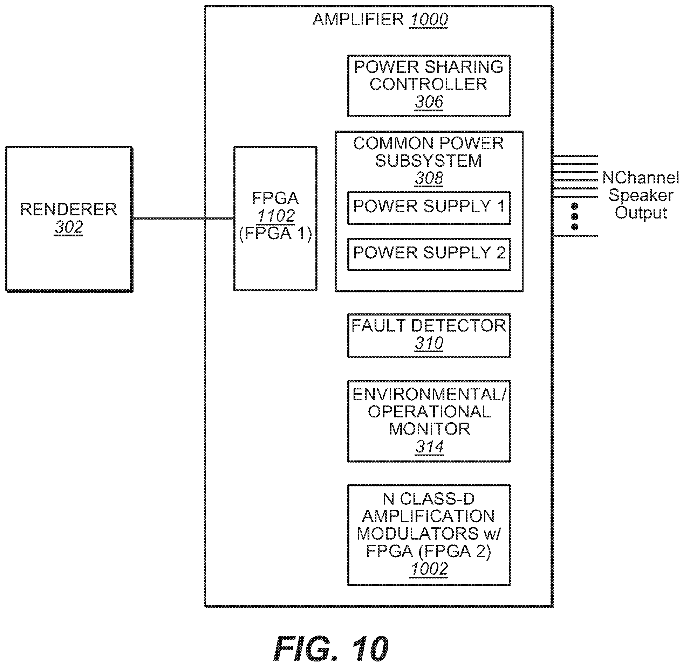

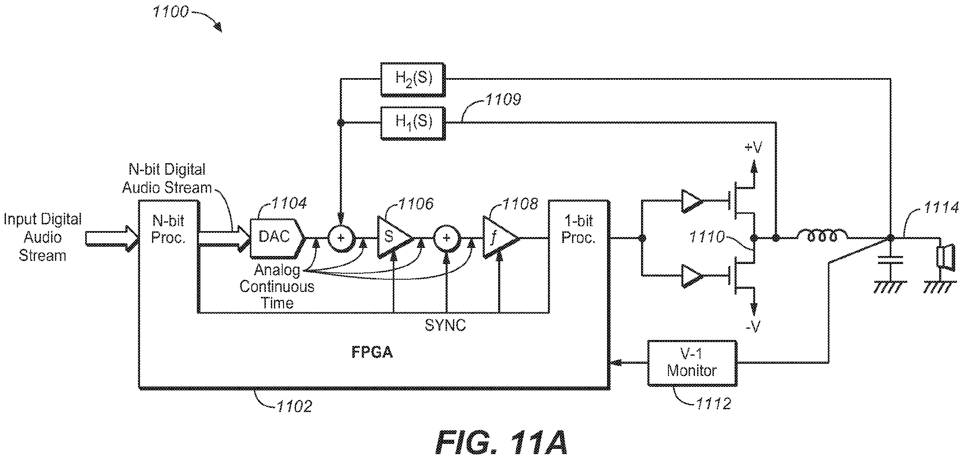

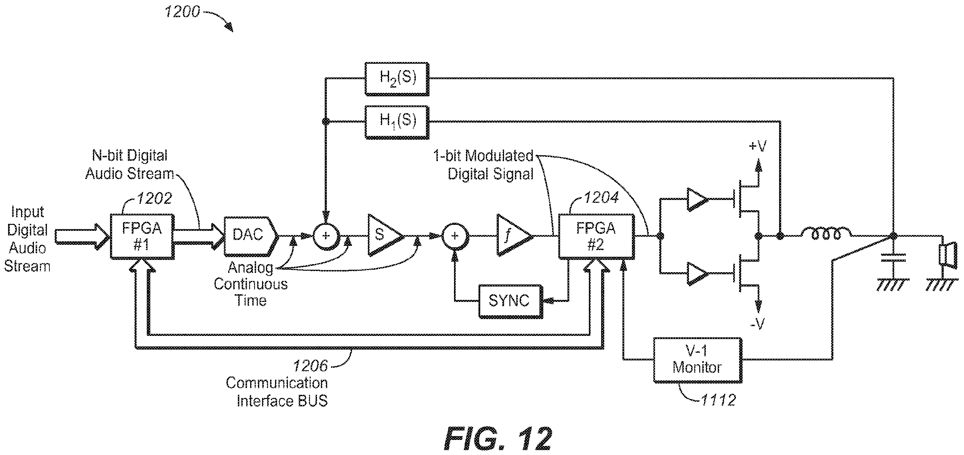

FIG. 10 illustrates the multi-channel amplifier of FIG. 3 with a front-end FPGA processing the input digital audio stream, under some embodiments. As shown in FIG. 10, amplifier 1000 includes substantially the same components as described above with reference to FIG. 3, but includes an FPGA device 1102 which receives the input digital audio stream directly from the renderer 302. The FPGA performs certain N-bit processing functions to generate an n-bit digital audio stream that is processed within the amplifier 1000 to generate a 1-bit processing output that is amplified to drive the N-channel speaker output. Amplifier 1000 also includes a new component 1002 that comprises a number (for N channels) of Class-D amplification modulators that may be implemented as an FPGA device or devices, or alternatively as discrete analog or digital circuits. For the FPGA embodiment, FPGA 1102 may correspond to FPGA #1 as shown below in FIG. 12, and component 1002 may correspond to FPGA #2 as shown below in FIG. 12, or they may be portions of FPGA 1102 shown in FIG. 11A.

FIG. 11A is a block diagram of the FPGA stage of amplifier 1000, under some embodiments. Circuit 1100 is generally based on and applies to a closed-loop Class-D amplifier. Input from the renderer in the form of a digital audio stream is received by an input interface of FPGA 1102. The N-bit stream is then converted to analog signals in DAC (digital-to-audio converter) 1104, which outputs an analog continuous time signal. This signal is integrated in integrator 1106. A synchronization (sync) or carrier signal is then injected into the output of the integrator for comparison in comparator 1108. The output from the comparator is then input to an output stage 1110 (that may also contain a filter circuit) and is converted through appropriate circuitry to generate the speaker feed signal 1114. In an embodiment, feedback is provided through one or more feedback elements 1109 that each feature respective transfer functions denoted $H_1(s)$ and H2(s). This feedback loop injects the output of filter 1110 back into the input of the integrator 1106. The feedback elements 1109 effectively affect the signal differently over a frequency range and become part of the input audio for purposes of error correction. If there is an error, the transfer functions $H_1(s)$, H2(s) can be used to provide corrective response.

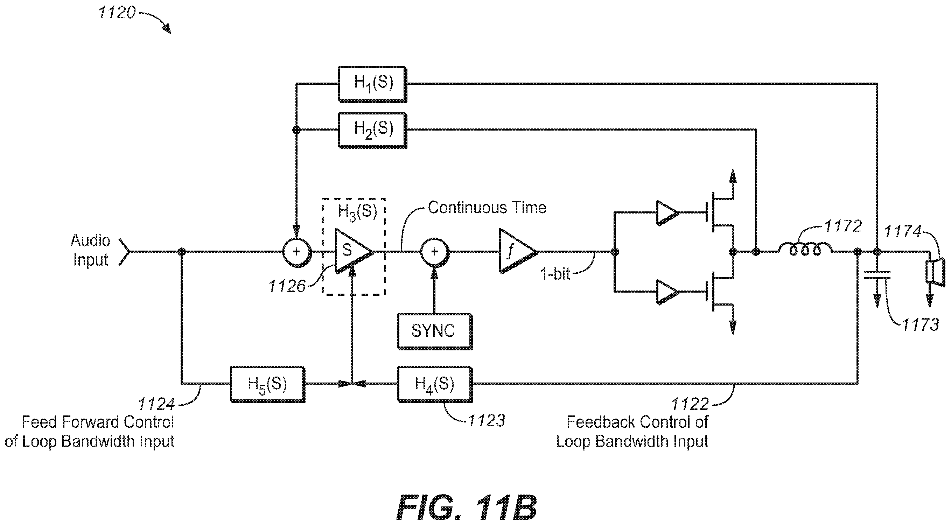

The integrator 1106 itself has a transfer characteristic denoted Z(s). Depending on the system configuration, it can be any type of transfer characteristic such as a low-pass filter, phase shift, or similar. In an embodiment, Z(s) is provided as a second-order fixed response filter. For example, it may be a low-pass filter with a certain phase response. Transfer characteristic Z(s) can be modulated by the control signal drawn from the FPGA leading into the integrator (or it can be modulated via path 1122 or 1124 in FIG 11B) to provide for a dynamic control for Z(s). This modulation function modulates the loop filter to increases the range of synchronization to the carrier. It effectively maximizes the modulation index (M) which represents how much the system is modulated and how broad M can get and maintain sync with the carrier. In an ideal system M approaches 100% so that sync is maintained over entire range of amp. The FPGA provides a sync signal that comprises a carrier signal or clock signal that is used to synchronize the input digital audio stream. In a non-FPGA embodiment, this signal is typically provided by an oscillator. In an embodiment, the system 1100 is configured to provide sync for up to approximately 95% duty cycle. Over this range, the system is modulated so that it does not lose sync over a significantly broad duty cycle range. This reduces the possibility of beat notes and other similar distortion effects as channels within the multi-channel amplifier lose sync from one another. In an embodiment, the multi-channel amplifier is configured to maintain sync to a master carrier 384kHz based on a word clock of 48kHz (i.e., the input sample rate). Circuit 1100 also improves the stability of the system by preventing oscillation at the system's natural frequency. The various transfer functions Z(s), $H_1(s)$, H2(s), delays, and resonances within the circuits are set so that there is adequate phase margin to reduce the chance of low frequency that is well below the frequency of the carrier (e.g., on the order of 80-100kHz) oscillations.

In an embodiment, FIG. 11A illustrates a modulator circuit for a single channel of a multi-channel amplifier. Any number of these channel modulator circuits may be used depending on the total number of channels in the amplifier.

FIG. 11B is a block diagram of a Class-D modulator stage with a loop bandwidth modulation circuit, under some embodiments. Diagram 1120 illustrates the circuit of FIG. 11A with a feedback control of loop bandwidth circuit 1122 and a feed forward control of loop bandwidth circuit 1124. These are shown as functional loop components in FIG. 11B, but should be understood to represent components implemented through the FPGA 1102 programmable logic. The feedback control loop 1122 includes a component 1123 that imparts a transfer function H4(s) on the output of the amplifier and inputs this to integrator circuit 1126. In an embodiment, transfer function H4(s) may be a signal processing function that functions as a rectifier, absolute value function (ABS) or DC bias as needed, and the like. In a practical embodiment, $H_4(s)$ comprises active rectification with some frequency shaping. Additional elements in this loop may attenuate the signal. As shown in FIG. 11B, an embodiment may also benefit from controlling the loop bandwidth via a feed-forward approach, wherein the input audio signal is used to modulate the loop bandwidth. In this manner, the system may use a combination or ratio of feedback and feed-forward control. It should be clear to one skilled in the art that such an approach could rely solely on feedback or feed-forward control of the loop bandwidth.

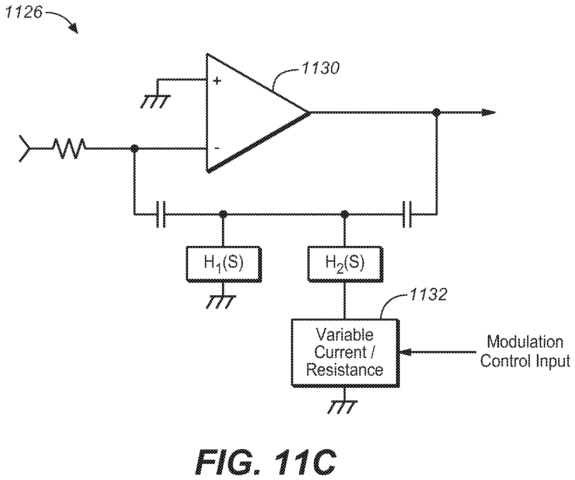

FIG. 11C is a detailed diagram of the integrator circuit 1126 for the output stage of FIG. 11B, under an embodiment. Integrator 1126 comprises an op-amp circuit 1130 that is a second-order integrator with fixed response. Control for this integrator can be a feedback or feed-forward signal (as described above) to modulate the loop bandwidth by dynamically changing the characteristics of the integrator. As shown in FIG. 11C, the modulation control input, which is shaped by transfer function H4(s), and could be an attenuated and rectified (ABS) version of the amplifier output signal, is input to a variable current/resistance circuit 1132. In an embodiment, this may be implemented as a JFET device, variable resistor, current mirror, transconductance amplifier, or similar circuit. This causes the integrator to no longer have a fixed transfer characteristic, but instead allows the amplitude and phase response to move with respect to the modulating signal. The ability to modulate the loop bandwidth by changing the characteristics of integrator provides a degree of phase boost that improves lock to the synchronization signal (Sync). It also helps keep THD low even at high gain levels by keeping the loop bandwidth wider than it would be without modulation. This system also improves the zero-crossing distortion (ZCD) that occurs with present Class-D amplifiers. By modulating the loop filter with the input audio signal, the JFET or other device 1132 is always driven at a level equal to absolute value of the magnitude of the input or output signal, or a combination of both. This design, in which the loop is modulated based on the input or output audio helps the amplifier maintain sync and feature THD across all gain levels. It does this by changing the frequency and phase response of the control loop, as opposed to changing gain as may be done in some current amplifier systems.

The loop modulator embodiment shown in FIGS. 11B and 11C may be implemented using programmable logic elements provided by FPGA 1102, or it may be implemented using discrete appropriate analog and/or digital circuit devices and components.

For the embodiment of FIG. 11A, FPGA 1102 of FIG. 11A is a unitary device that monitors the signals that are input into the amplifier through an N-bit processing front-end, and monitors the output of the channel modulator section through the 1-bit processing back-end. This 1-bit processing section effectively watches the channel modulator operation on a bit-by-bit basis (or pulse-by-pulse basis for a PWM signal) while the front-end effectively monitors what is received by amplifier 1100. Thus, the FPGA monitors what drives the input to the amplifier and what is output from the continuous Class-D amplifier section. The FPGA is programmed to perform certain monitor/control functions, as mentioned above. For the embodiment of FIG. 11A, a voltage-current monitor 1112 takes the speaker feed output 1114 and inputs it into the FPGA 1102 for certain monitoring functions.

The configuration of the FPGA 1102 may be different based on certain system designs, and may be a single unitary device as shown in FIG. 11A, or it may be distributed among two or more devices, programmable or otherwise. FIG. 12 illustrates a multi-FPGA system for a Class-D modulator for a multi-channel amplifier. For this example, the FPGA circuit and functionality of FIG. 11A is divided between FPGA device 1202 and FPGA device 1204, and these two FPGA devices are coupled together over communication interface bus 1206. The remaining components and signals operate as described above with respect to FIG. 11A. For the embodiment of FIG. 12, FPGA 1202 performs the front-end monitoring of the input digital audio stream, while FPGA 1204 monitors the 1-bit modulated digital signal from the Class-D modulator stage of amplifier 1200. As shown in FIGS. 11 and 12, the FPGA-based modulator circuit provides synchronization control in that the FPGA derives a synchronization clock for the modulator and monitors the 1-bit PWM for sync-lock status.

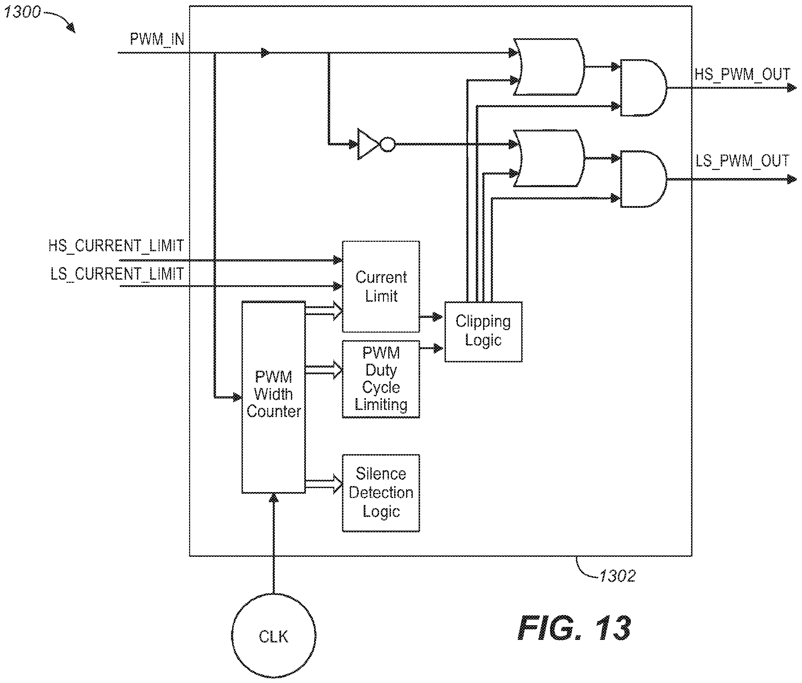

In an example, the FPGA component 1102 of FIG. 11A includes a PWM control and monitoring circuit, such as shown in FIG. 13. In diagram 1300, the PWM control and monitoring circuit 1302 receives as input the PWM_IN signal from the PWM monitor, a clock signal (e.g., 196.6 MHz) along with HS and LS current limit level signals. The circuit 1302 contains certain control components such as a PWM width counter, current and duty cycle limiters, silence detection logic, clipping logic and certain combinatorial logic devices to produce the HS and LS PWM-OUT output signals 1304. This circuit performs at least part of the task of monitoring the PWM duty cycle to detect certain conditions (e.g., channel overdrive) so that the amplifier or system controllers can take compensatory actions, such as gain limiting, and so on.

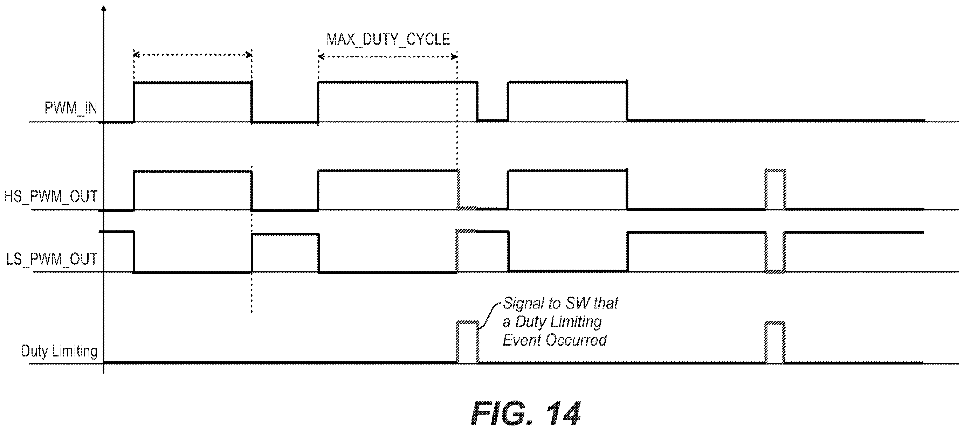

FIG. 14 illustrates example waveforms for the PWM pulse length measurement performed by the PWM circuit of FIG. 13, under an embodiment. FIG. 14 illustrates the relationship among the PWM_in and PWM_out signals for certain example output states. The condition that generates a duty limiting signal to communicate that duty limiting occurs when the PWM_in signal exceeds "MAX_DUTY_CYCLE" length. The algorithm then terminates the PWM_out signal as needed, to keep the PWM_out duty cycle always equal or less than MAX_DUTY_CYCLE".

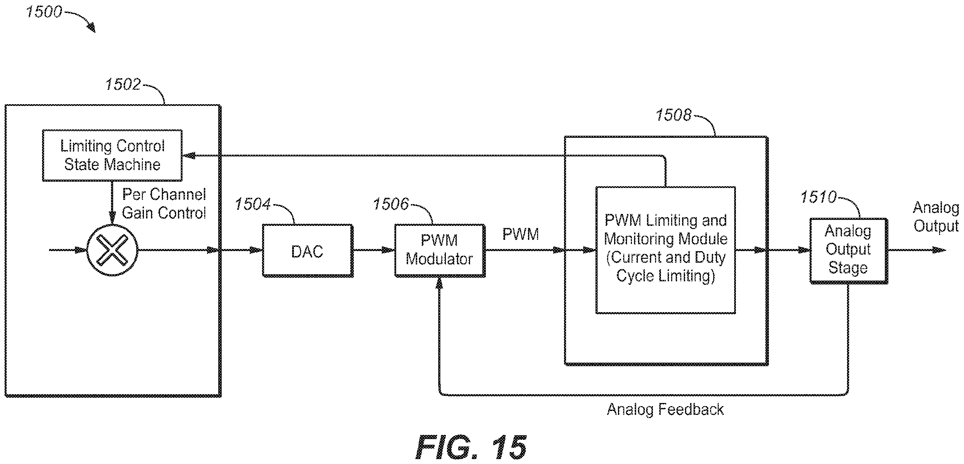

In an example, the FPGA device 1102 may include a gain control module for controlling the gain of each individual channel to compensate for any overdrive conditions, or other control reasons. FIG. 15 illustrates a gain control module that can be implemented in the programmable logic of the Class-D modulator circuit of FIG. 11A or FIG. 12 under some embodiments. In an embodiment, channel gain is controlled by a duty limiting or current limiting waveform. The FPGA monitors the on-bit PWM and adjust the multipliers used in the front-end, thereby attenuating the audio input stream. FIG. 15 illustrates duty/current limiting module that can be implemented in the programmable logic of the Class-D modulator circuit of FIG. 11A or FIG. 12. As shown in FIG. 15, the module 1500 includes a first FPGA component (or portion) 1502 that implements a limiting control state machine to output a per-channel gain signal. This is combined with the input audio that is input to DAC 1504 and the PWM modulator section 1506. The output of the modulator 1506 is a PWM single that is limited by a second FPGA component (or portion) 1508. This component current and/or duty cycle limits the PWM signal according to the gain control state machine signal, and the output is sent to audio output stage 1510. An analog feedback loop is provided from the analog output stage 1510 to the PWM modulator 1506. In an embodiment, the per-channel gain control may be performed by the limiting and monitoring module of component 1508 transmitting a set of serialized status bits for a number of channels of duty cycle limiting and another number of channels of current limiting back to the state machine in component 1502.

The circuit of FIG. 15 may effectively implement an autogain control state machine that takes as inputs certain programmable parameters such as attack and release parameters, gain set values, and clip inputs for the channels, among other inputs. The output of the state machine controls the multiplier used on the audio input stream, thus allowing the audio output to be equal or less than then audio input. If the "current gain" setting is less than 1, the multiply operation will result in an attenuation of audio input, and effectively reduce the amplitude of audio output. For the example of FIG. 15, component 1702 may correspond to FPGA #1 1202 of FIG. 12 and component 1708 may correspond to FPGA #2 1204 of FIG. 12.

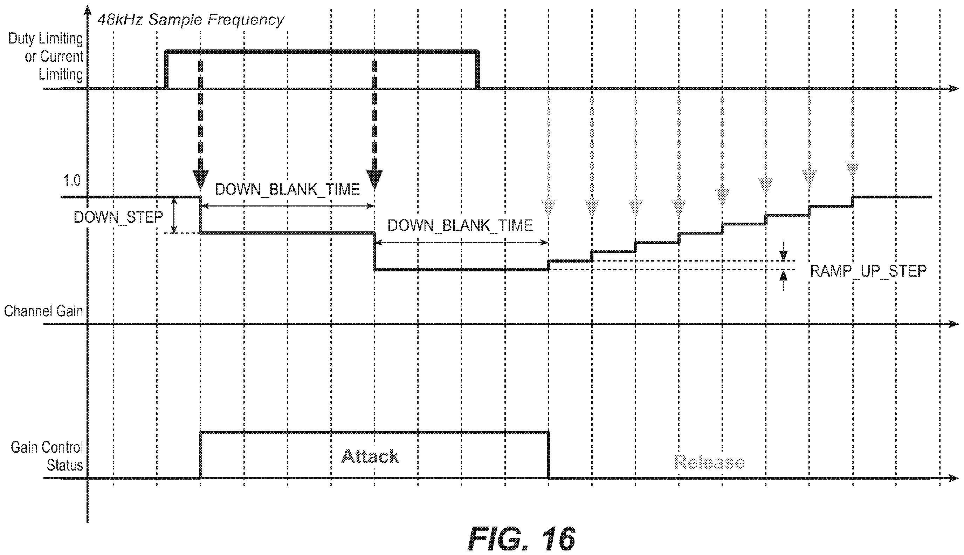

FIG. 16 illustrates example waveforms for duty limiting and channel gain functions performed by the gain control circuit of FIG. 15, under an embodiment. FIG. 16 illustrates the relationship among the duty limiting or current limiting signals for certain example gain control states, such as during an attack and release phase. The channel gain waveform illustrates the reduction in gain during an attack phase and a subsequent ramp-up in gain during the release phase.

In addition to monitoring the PWM duty cycle and current limit signals to effectively trigger gain reduction algorithms, the FPGA 1102 may also be used to monitor the main amplifier voltage rails and reduce audio gain when various voltage rail perturbations occur. For example, in one embodiment the amplifier output stage voltage rails are monitored for over voltage scenarios, such as might occur during bus pumping phenomena. When the amplifier output stage voltage rails exceed a nominal over-voltage threshold, the gain multiplier for that amplifier channel or group of channels can be reduced to limit bus pumping.

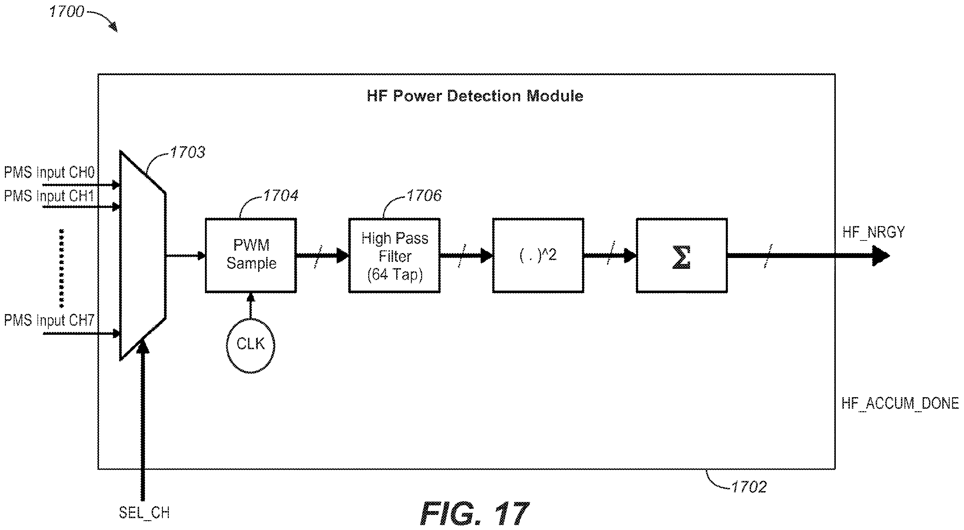

In an embodiment, the Class-D modulator circuit may also include a power detection module, such as shown in FIG. 17. Circuit 1700 illustrates a high-frequency power detection module 1702 that detects high-frequency power for 8 different PWM channels, though other channel counts are possible depending on the size of multiplexer 1704. For a selected channel, a sampler 1706 takes a defined sample for a set frequency range. This sample is input to a high pass filter 1708 and processed to produce a high-frequency energy signal. This signal can then be used by control circuitry to trigger gain limiting or other compensatory measures in the event of excess power consumption by any of the PWM channels. This feature can also be viewed as a protective measure to ensure that no high-frequency energy is continuously transmitted to the load, and potentially lead to load damage, i.e., loudspeaker failure. The high-pass filter can be configured to pass signals above a defined frequency, such as on the order of 20kHz and cut those below the defined frequency.

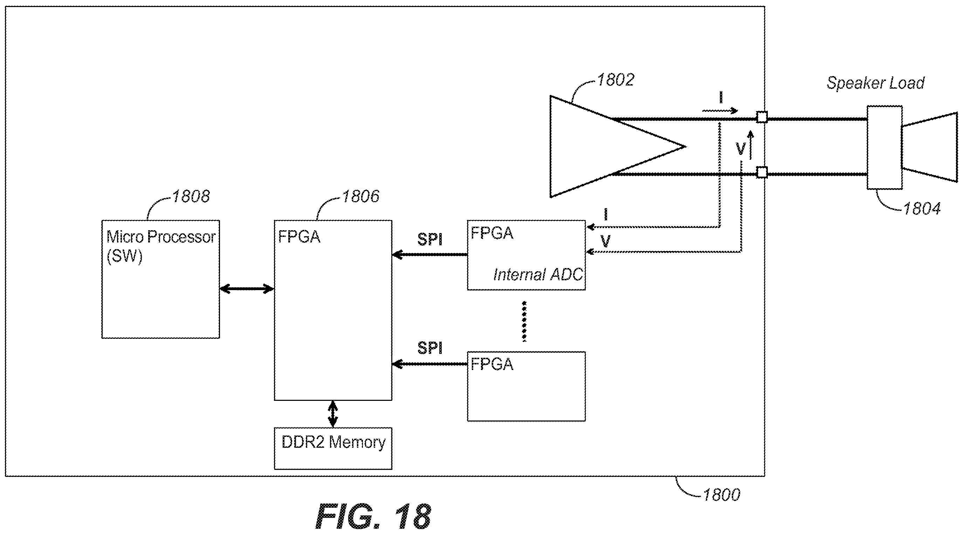

As shown in FIG. 11A, circuit 1100 includes a V-I monitor that monitors the current and voltage levels at the audio output stage. FIG. 18 illustrates an FPGA-based circuit that monitors the current and voltage levels for audio signals input to a speaker, under some embodiments. As shown in FIG. 18, amplifier 1800 has an output amp stage 1802 that drives a speaker load 1804 through speaker feed having current (I) and voltage (V) characteristics. This current/voltage level information is fed into an FPGA or FPGA array 1806. This data is then used by a controller 1808 to compensate for any failure or error conditions, such as a failed amp stage, excessive output signal level, blown speaker, and so on. For the FPGA input, external or internal ADC's may be used to convert the analog I-V signals to digital form.

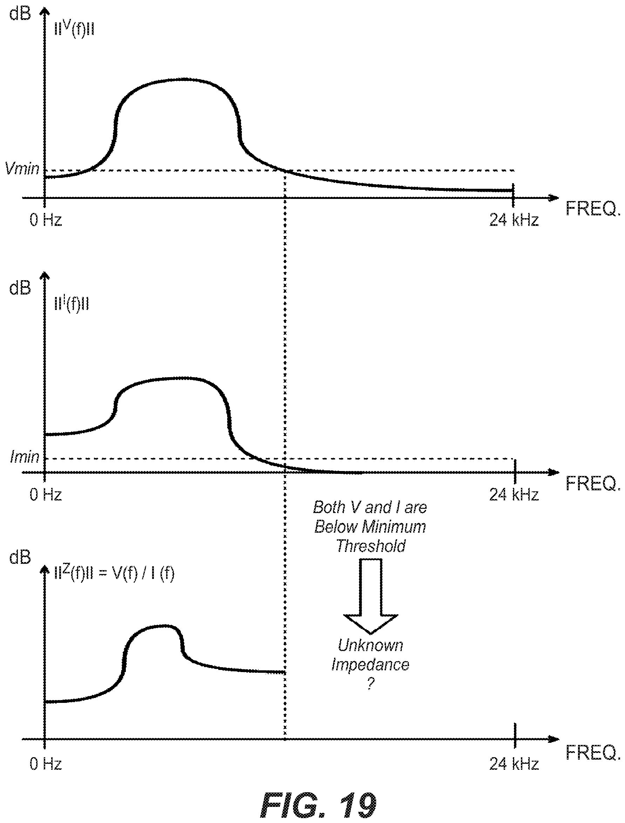

In an embodiment, the current/voltage monitoring circuit of FIG. 18 may be used to monitor speaker health and compensate for any physical speaker failures. Failure modes may be detected based on comparison to Zmax and Zmin characteristic curves determined during a speaker or system calibration phase. FIG. 19 illustrates example waveforms for calculating the impedance of a speaker using current-voltage characteristic curves, under some embodiments. As shown in FIG. 19, a voltage transfer curve ($\|V(f)\|$) and a current transfer curve ($\|I(f)\|$) can be used to calculate the impedance of a driver with an unknown impedance through the calculation:

$$\|Z(f)\| = V(f)/I(f).$$

Other features and elements may also be implemented in the FPGA 1102, including: precision dead-band timing with dynamic capability, and programmable delay line, among others. With respect to dead-band timing, in one embodiment the FPGA can be used to control the dead-band timing of the two critical PWM output signals HS_PWM_OUT and LS_PWM_OUT. Typically, in Class-D amplifiers it is advantageous to insert a small amount of time where both the high-side and low-side MOSFET transistors are in the OFF state, otherwise referred to as "dead time" or "dead-band time." The amount of dead-band time needed for any given MOSFET can change depending upon the characteristics of the MOSFET, the MOSFET gate drive circuit, the MOSFET drain current, and other factors. Increased dead-time also leads to increased THD in the amplifier, therefore, it is desirable to minimize dead-time, but permit enough time for the MOSFETs to adequately turn-off and turn-on without any significant overlapping cross-conduction. By employing an FPGA within the 1-bit PWM path of a Class-D amplifier, the dead-band timing can be precisely controlled and dynamically adjusted as needed to accommodate maximum audio fidelity, while maintaining sufficient cross-conduction mitigation. It should also be noted that using a clocked FPGA for said dead-band timing generation has the inherent advantage of precision timing when compared to passive dead-band timing schemes that suffer from component tolerance.

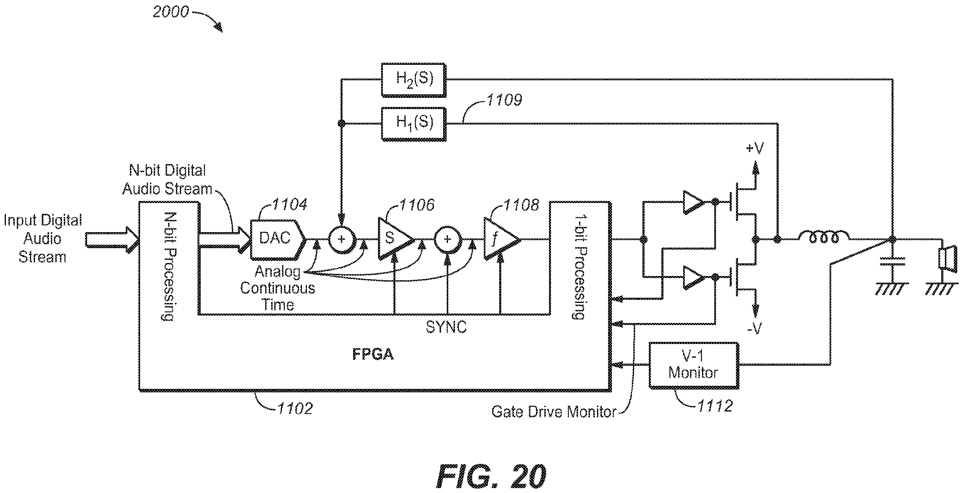

FIG 20 illustrates an example wherein the FPGA monitors the gate drive characteristics of each MOSFET and can employ programmable dead-band timing to provide the shortest possible dead-band timing for any given load and MOSFET arrangement, thereby providing the lowest THD impact. Circuit 2000 of FIG. 20 represents a modification of circuit 1100 of FIG. 11 in which a gate drive monitor circuit 2002 is placed at the output of the circuit to provide monitor feedback to FPGA 1102. This is one possible configuration of the gate drive monitor circuit, and embodiments are not so limited.

In one example, the FPGA component(s) described herein can be used to control the total loop delay seen throughout the overall control loop. Because the loop delay impacts the phase shift and thus can impact the natural switching frequency of the modulator, the FPGA can adjust the delay to ensure all channels are performing with the same phase characteristic. The FPGA can monitor the propagation delay dynamically or use a self-calibration algorithm to determine the net delay. Using 1-bit programmable delay lines allows the FPGA to adjust the overall delay to meet a predetermined target.

Transconductance Amplifier

As stated above, in an example, the variable current circuit 1132 for the loop bandwidth modulator may be implemented as a transconductance amplifier. In an embodiment, the transconductance amplifier is an operational transconductance amplifier that functions as a voltage-controlled resistance in which the transconductance element is configured with local feedback allowing for variability in bandwidth, quiescent current, and gain. In general, a transconductance amplifier has a high impedance terminal; a low impedance terminal that can be considered either as an input or an output depending on the circuit; and an output current source terminal (which is high impedance). Any voltage that appears between the low and high impedance terminals will generate a current that flows out of the output current source terminal.

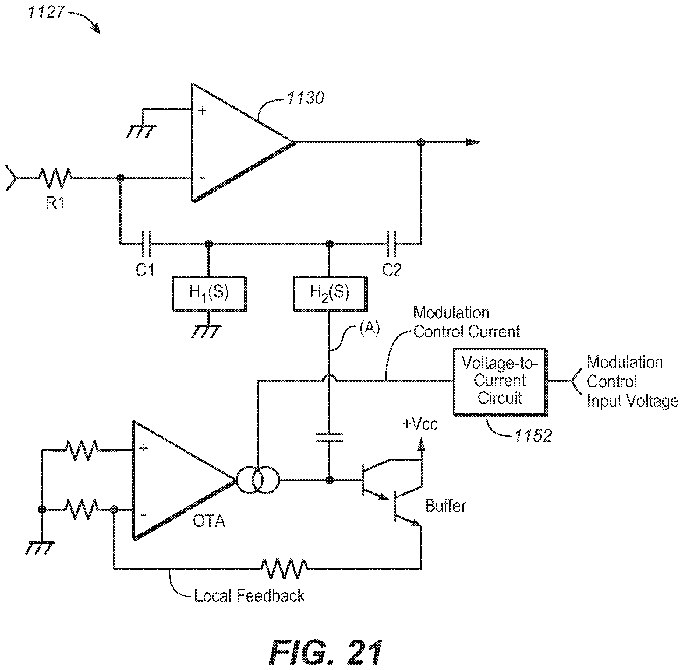

FIG. 21 illustrates a diagram of an integrator circuit 1127 for the modulation stage 1126 of FIG. 11B, in which a transconductance amplifier (OTA) is used as the variable resistance circuit 1132 of FIG. 11C. In this embodiment, the voltage at circuit node A produces an input to the differential input stage of the transconductance amplifier, wherein this signal is effectively multiplied by the gain of the transconductance stage, which is a direct function of the modulation control input current. In this configuration, the effective resistance seen at circuit node A is directly proportional to the modulation control current and the local feedback utilized in the transconductance stage. The modulation control current is derived from the modulation control voltage via a voltage-to-current circuit 1152 that typically consists of resistive elements. The resulting voltage controlled resistance is then attached to circuit block H2(s). Circuit block H2(s) represents any circuit that has a nominal transfer function that can be implemented by the designer. In certain examples, $H_2(s)$ is effectively a broad-band, short-circuit pass through allowing the voltage controlled resistance of circuit node A to directly impact the primary integrator of the Class-D amplifier. In other cases, $H_2(s)$ may be implemented to limit the effective frequency range of the variable resistance seen at circuit node A. While not limited to this exact integration configuration, modulating the resistance seen at circuit node A effectively moves the poles of the integrator formed by operational amplifier 1130, R1, C1, and C2.

It should be noted that the transconductance amplifier may be implemented as any appropriate integrated circuit element/device or it may be built from a combination of discrete transistor and RC components. As stated above, other similar variable current circuits may be used in addition or instead of the transconductance amplifier, such as current mirrors, and the like.

In an example, the loop modulator embodiment shown in FIGS. 11B and 11C may be implemented using programmable logic elements provided by FPGA 1102, or it may be implemented using discrete appropriate analog and/or digital circuit devices and components.

For the example of FIG. 11A, FPGA 1102 is a unitary device that monitors the signals that are input into the amplifier through an N-bit processing front-end, and monitors the output of the channel modulator section through the 1-bit processing back-end. This 1-bit processing section effectively watches the channel modulator operation on a bit-by-bit basis (or pulse-by-pulse basis for a PWM signal) while the front-end effectively monitors what is received by amplifier 1100. Thus, the FPGA monitors what drives the input to the amplifier and what is output from the continuous Class-D amplifier section. The FPGA is programmed to perform certain monitor/control functions, as mentioned above. For the embodiment of FIG. 11A, a voltage-current monitor 1112 takes the speaker feed output 1114 and inputs it into the FPGA 1102 for certain monitoring functions.

The configuration of the FPGA 1102 may be different based on certain system designs, and may be a single unitary device as shown in FIG. 11A, or it may be distributed among two or more devices, programmable or otherwise. In either configuration, the FPGA-based modulator circuit provides synchronization control in that the FPGA derives a synchronization clock for the modulator and monitors the 1-bit PWM for sync-lock status.

Termination/Detector Circuit

The loop bandwidth circuit of FIG. 11B includes an inductor/capacitor (LC) circuit comprising an inductor 1172 and a capacitor 1173 coupled to ground and to a speaker 1174. When the speaker 1174 is present on the output of the circuit a normal load is present. When no loudspeaker is connected, however, the circuit is unterminated and has an open load. In an open load condition, the natural resonance of the LC circuit results in a large phase shift at resonance, which can cause certain instability issues within the feedback control loop. These instabilities can lead to unwanted high-frequency oscillations, and other similar effects.

Open load conditions can be caused by blown or malfunctioning speakers as well simply leaving the speaker terminals unattached to speakers, which may be common in high channel count (e.g., 32 channel) or multi-stage (e.g., 64 channel) amplifiers. Depending on deployment and configuration scenarios, certain conditions such as a high frequency stimulus, such as may be caused by a hard-clipping condition on a channel or driving the amp with a square wave may cause a situation in which the power supply running all 32 (or other high number) channels is unable to hold the power rails sufficiently high enough when the channel output demands are high. In this case, the one or more open-load channels can fully clip causing high-frequency oscillation. Such an oscillation condition, if left undamped could lead to cross-channel distortion (e.g., audio artifacts), wasted power, overheating conditions, and so on. In an example, the LC output stage features a built-in termination circuit that loads the LC circuit by creating a low-impedance load to keep the LC circuit from oscillating when there is no speaker or external load attached. In an example, this termination scheme provides robustness to the loop bandwidth modulation circuit and to the output stages of the high-channel count amplifier, in general. Such a circuit may also provide a high-frequency detection function that can be used to detect an open load condition and/or the onset or presence of high-frequency oscillations on the output stage of the amplifier.

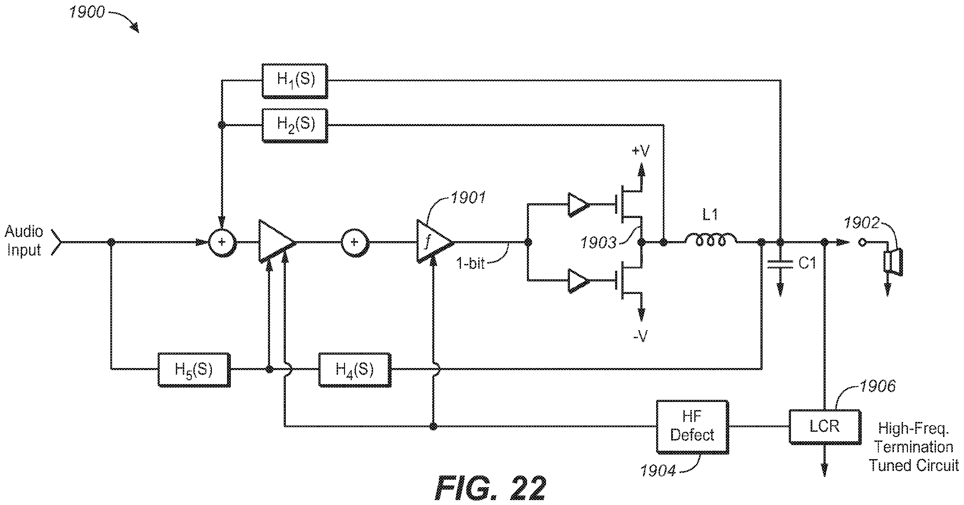

FIG. 22 is a block diagram of the Class-D modulator stage of FIG. 11B with a loop bandwidth modulation circuit and high frequency detection and termination tuned circuit. As shown in diagram 1900, the overall modulator stage 1901 has an LC output stage comprising inductor L1 and capacitor C1, which together comprise an output filter that is connected to the output of a bridge circuit 1903, which may be implemented as a transistor (e.g., MOSFET) bridge circuit. In an audio amplifier application, the output of this filter ends in a speaker connection port for detachable coupling of a speaker 1902. When such a speaker is attached, the amplifier output stage has sufficient load to prevent any LC resonance issues. If no speaker is attached, however, an open load condition exists. To fix this issue, a high frequency LCR (inductor-capacitor-resistor) circuit 1906 is provided to damp the natural LC resonance and prevent or minimize any high-frequency oscillation effects. In an embodiment, circuit 1906 is a tuned LCR circuit that is configured to provide a level of impedance termination at the natural resonant frequency of the primary L1/C1 output filter. This circuit thus provides damping of this resonance. The resonant frequency of the primary output filter is defined by the equation:

$$f_0 = \omega_0/2\pi = 1/(2\pi \text{SQRT}(LC))$$

The natural resonance of an undamped LC circuit results in a drop or minimization of the amplifier output impedance and a significant phase shift at the resonant frequency. The tuned termination circuit 1906 provides a low-impedance load to properly terminate and dampen the LC output filter, and helps overcome this natural drop in the output impedance and reduces the slope of the phase shift associated with the LC filter. In an example implementation, the L1/C1 output filter circuit may have a resonant frequency of about 45kHz manifesting in a localized peak or bump in gain at this frequency. The LCR termination circuit 1906 imposes a notch at this frequency to counteract this effect. The LCR circuit 1906 generally comprises at least one inductor-capacitor-resistor circuit in any appropriate configuration to attenuate or rectify the bump in gain caused by the L1/C1 resonant frequency. For example, the LCR circuit may be configured in a traditional series configuration, or in a high-pass filter configuration.

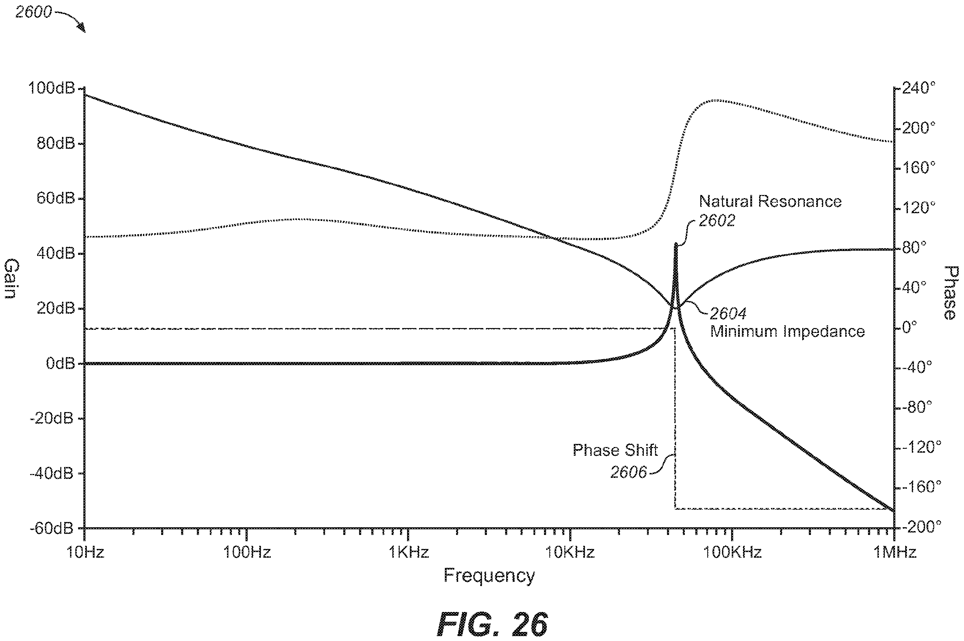

FIG. 26 illustrates example plots of frequency versus gain and phase for tuned termination circuit, under an embodiment. As shown in diagram 2600, the example natural resonance 2602 of the unterminated LC output filter has a peak around 45kHz. For this frequency, the minimum impedance 2604 of the LCR termination circuit is set with a matching negative gain (attenuation) factor. Step function 2606 illustrates the rapid phase shift at resonance of the unterminated LC output filter. FIG. 26 is intended to illustrate an example plot of a natural resonance of an output filter circuit and the use of a LCR termination circuit to counteract this effect, and many other plots are also possible depending on the output filter circuit values.

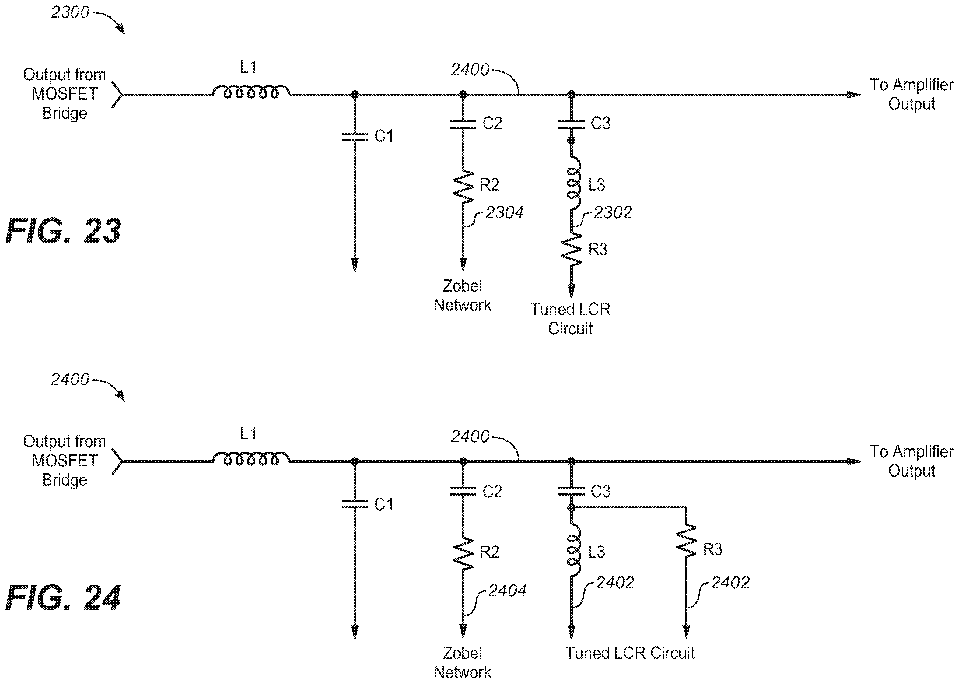

FIG. 23 illustrates an LCR termination circuit of FIG. 22 in a series configuration, under an embodiment. As shown in circuit 2300, the output of the transistor bridge (e.g., circuit 1903 of FIG. 22) is coupled to the L1/C1 output filter circuit. The tuned LCR circuit 1002 comprising the termination circuit (e.g., circuit 1906) comprises capacitor C3, inductor L3, and resistor R3 connected in series to ground as shown in FIG. 23. This is the final circuit stage before the speaker connector that comprises the amplifier output. For the embodiment of FIG. 23, the order of the LCR components is illustrated as CLR to ground, but other component orderings are also possible.

FIG. 24 illustrates an LCR termination circuit of FIG. 22 in a high-pass filter configuration. For this embodiment, circuit 2400 has a tuned LCR circuit 2402 comprising a capacitor C3 connected in series to a parallel array of inductor L3 and resistor R3. This configuration provides a tuned high-pass filter effect to counteract the resonant frequency of the L1/C1 output filter. As appreciated by those of ordinary skill in the art, the appropriate values and types of resistor, capacitor, and inductor devices may be selected depending on the characteristics of the L1/C1 output filter circuit and the amplifier in general. Although FIGS. 22 and 23 illustrate specific configurations of the LCR components, it should be noted that other configurations are also possible and can be tailored to provide the appropriate attenuation and/or filtering of the output filter resonance frequency.

The examples of FIG. 22 and 23 both include an optional Zobel filter network 2304 or 2404 consisting of a capacitor C2 and a resistor R2 connected in series to ground. Such a circuit may or may not be included in the LCR termination circuit 1906. In general, a Zobel network is a circuit in which the input impedance is set independently of the transfer function. In an amplifier application, the Zobel network (e.g., 2304) serves to present a steady resistance to the output LC filter at frequencies above the natural cutoff of the RC Zobel network. In general, the impedance of a speaker is partly resistive, but it also exhibits some degree of inductance due to the windings of its coil. The impedance of the loudspeaker is thus typically modelled as a series resistor and inductor. The Zobel network provides a parallel RC circuit to form a Zobel bridge that compensates for the LR impedance of the speaker and also helps to provide a high frequency termination when the amplifier is not connected to a loudspeaker or other similar load.

The example of FIG. 22 also includes a high-frequency detection circuit 1904. This circuit is configured to detect a high frequency condition at the output stage of the modulator stage 1901. As shown in diagram 1900, circuit 1904 is coupled to an output of the termination circuit and is configured to provide feedback to the front end of circuit 1900, to prevent the circuit from losing stability. In this configuration, it can also act to adjust the loop bandwidth of the modulator stage 1901 by adjusting the characteristics of the transconductance amplifier (or current mirror, JFET circuit). In this configuration, the termination circuit 1906 signal is fed back to provide control feedback for loop bandwidth or to provide current control, which is independent of the loop bandwidth.

In another example, the output of the high frequency detection circuit can be fed to the 1-bit logic stage or comparators within the front-end of the Class-D amplifier of circuit 1900, wherein the logic stage can act appropriately to curtail the undesired high frequency energy detected by circuit 1904. In one example, the output of high frequency detector 1904 is fed to a logic stage that results in immediate cycle-by-cycle termination of the modulating PWM signal, thus quickly eliminating the high frequency energy present at the output. Such logic stages may be implemented within programmable devices such as FPGA devices or CPLD (Complex Programmable Logic Device).

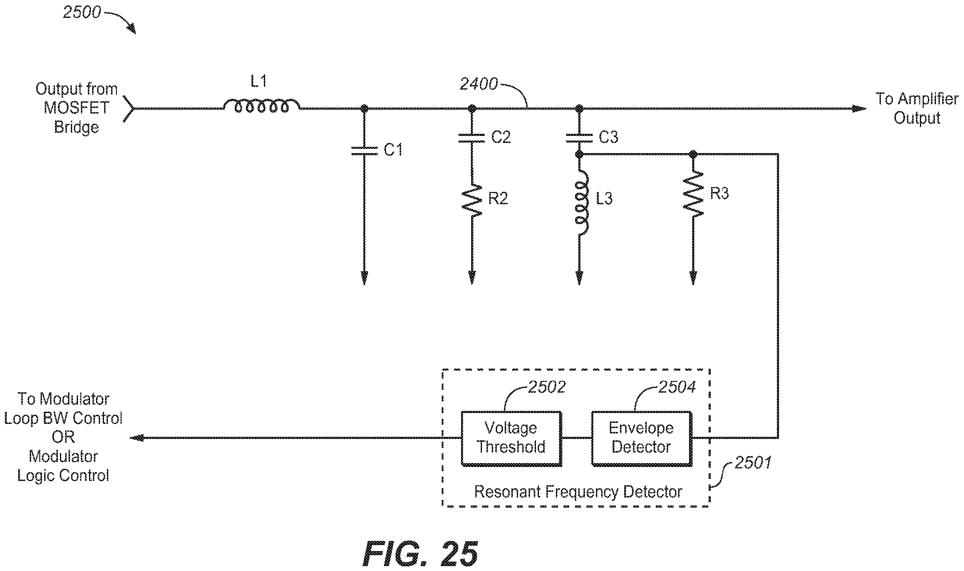

FIG. 25 illustrates a high-frequency detection circuit for the termination circuit of FIG. 24. As shown in FIG. 25, circuit 2500 is composed of the high-frequency detection circuit 2400 of FIG. 24 with the addition of a resonant frequency detector circuit 2501 coupled to an output node of the LRC filter made up of capacitor C3 coupled to inductor L3 and resistor R3. The resonant frequency detector 2504 has an envelope detector 2504 and a voltage threshold detector 2502. The envelope detector 2504 takes as an input the (high-frequency) signal from the LRC filter and provides an output which is the envelope of this input signal, which is a smooth curve outlining its extremes. This envelope signal is input to the voltage threshold detector, which compares the envelope to a defined threshold voltage level. If the threshold voltage is exceeded, this indicates the circuit outputting a signal at the resonant frequency of the L1/C1 output filter or an excessively high frequency on the output of the amplifier. The output of the voltage threshold detector is then sent as a modulator loop bandwidth control signal to alter the loop bandwidth. Alternatively, the output of the voltage threshold detector may be sent to a modulator control circuit to provide current limiting and/or other modulator control functions.

Although shown in conjunction with termination circuit 2400, it should be noted that the resonant frequency detector 2501 can also be configured to operate with other types of termination circuits, such as the series RLC circuit 2302 of FIG. 23, as well as other possible tuned LCR or tuned resonant frequency circuits that provide open load termination.

Although embodiments of the termination 1906 and high-frequency detection circuit 1904 are shown as used in a loop bandwidth modulation circuit for a Class-D amplifier, embodiments are not so limited. Either or both circuits can be used in conjunction with any appropriate audio amplifier and with or without a loop bandwidth modulation circuit. The detection circuit 1904 can be used. In one example, the termination circuit is optimized for use with a closed-loop Class-D amplifier with feedback after the output filter.

Although example implementations are described with respect to certain specified components, such as the Dolby CP850, it should be noted that embodiments are not so limited and any similar or other appropriate component may be used.

Embodiments of the audio amplifier described herein may be used in any appropriate venue or application, such as cinema, home cinema, live venue, auditorium, industrial facility, military facility, theme park, and so on.

Unless the context clearly requires otherwise, throughout the description and the claims, the words "comprise," "comprising," and the like are to be construed in an inclusive sense as opposed to an exclusive or exhaustive sense; that is to say, in a sense of "including, but not limited to." Words using the singular or plural number also include the plural or singular number respectively. Additionally, the words "herein," and "hereunder" and words of similar import refer to this application as a whole and not to any particular portions of this application. When the word "or" is used in reference to a list of two or more items, that word covers all of the following interpretations of the word: any of the items in the list, all of the items in the list and any combination of the items in the list.

## Claims

1. An audio amplifier comprising:

a power supply stage (308) coupled to a mains power supply and providing power to drive channels corresponding to speaker feeds to a plurality of speakers (508);

for each channel, a continuous-time Class-D modulator (1100) with an embedded programmable logic device; wherein the modulator comprises a digital-to-analog-converter (1104) configured to convert an N-bit input digital audio stream for the channel to an analog continuous time signal;

wherein the modulator comprises a front-end integrator (1106) having a transfer characteristic, configured to integrate the analog continuous time signal; wherein the modulator comprises means for injecting a carrier signal into an output of the integrator, to provide an intermediate signal; wherein the modulator comprises a comparator (1108) for comparison of the intermediate signal; wherein the modulator comprises an output stage (1110) comprising a filter circuit; wherein the output stage is coupled to an output of the comparator and wherein the output stage is configured to generate a speaker feed signal for driving a speaker for the channel; and

for each channel, a feedback control loop (1122) configured to impart a first transfer function ($H_4(s)$) on the speaker feed signal to provide a first control signal for modulating the transfer characteristic of the integrator,

2. The audio amplifier of claim 1, further comprising, for each channel, a feed-forward control loop configured to impart a second transfer function (H (s)) on the analog continuous time signal to provide a 5 second control signal, wherein the transfer characteristic of the integrator is configured to be modulated by a combination or ratio of the first and the second control signals.

3. The audio amplifier of claim 1 or 2 wherein the embedded programmable logic device comprises a field programmable gate array (FPGA) device integrated in the amplifier.

**Patentansprüche**

1. Audioverstärker, umfassend:

eine Stromversorgungsstufe (308), welche an ein Netzgerät gekoppelt ist und Strom bereitstellt, um Kanäle anzusteuern, welche Lautsprecherwegen zu einer Vielzahl von Lautsprechern (508) entsprechen;

für jeden Kanal, einen zeitkontinuierlichen Klasse-D-Modulator (1100) mit einem integrierten programmierbaren Logikbaustein; wobei der Modulator einen Digital-Analog-Wandler (1104) umfasst, welcher konfiguriert ist, einen digitalen N-Bit-Eingangsaudiostrom für den Kanal in ein analoges zeitkontinuierliches Signal zu wandeln;

wobei der Modulator einen Front-End-Integrator (1106), der einer Transfercharakteristik aufweist, welche konfiguriert ist, das analoge zeitkontinuierliche Signal zu integrieren; wobei der Modulator Mittel zum Injizieren eines Trägersignals in einen Ausgang des Integrators umfasst, um ein Zwischensignal bereitzustellen; wobei der Modulator einen Komparator (1108) für den Vergleich des Zwischensignals umfasst; wobei der Modulator eine Ausgangsstufe (1110) umfasst, welche einen Filterschaltung umfasst; wobei die Ausgangsstufe an einen Ausgang des Komparators gekoppelt ist und wobei die Ausgangsstufe konfiguriert ist, ein Lautsprecherwegsignal zum Ansteuern eines Lautsprecherwegs für den Kanal zu erzeugen; und

für jeden Kanal, eine Rückmeldungssteuerungsschleife (1122), welche konfiguriert ist, eine erste Transferfunktion ($H_4(s)$) auf dem Lautsprecherwegsignal zu übermitteln, um ein erstes Steuersignal zum Modulieren der Transfercharakteristik des Integrators bereitzustellen.

2. Audioverstärker nach Anspruch 1, weiter für jeden Kanal eine Vorwärtswegsteuerschleife umfassend, welche konfiguriert ist, eine zweite Transferfunktion ($H_5(s)$) auf dem analogen zeitkontinuierlichen Signal zu übermitteln, um zweites Steuersignal bereitzustellen, wobei die Transfercharakteristik des Integrators konfiguriert ist, durch eine Kombination oder ein Verhältnis des ersten und des zweiten Steuersignals moduliert zu werden.

3. Audioverstärker nach Anspruch 1 oder 2, wobei der integrierte programmierbare Logikbaustein eine Field Programmable Gate Array (FPGA)-Vorrichtung umfasst, welche in den Verstärker integriert ist.

**Revendications**

1. Amplificateur audio comprenant :

un étage d'alimentation électrique (308) couplé à une alimentation électrique principale et fournissant de l'électricité à des canaux d'entraînement correspondant à des alimentations de haut-parleur à une pluralité de haut-parleurs (508) ;

pour chaque canal, un modulateur de classe D en temps continu (1100) avec un dispositif logique programmable intégré ; dans lequel le modulateur comprend un convertisseur numérique-analogique (1104) configuré pour convertir un flux audio numérique d'entrée à N bits pour le canal en un signal en temps continu analogique ;

dans lequel le modulateur comprend un intégrateur frontal (1106) présentant une caractéristique de transfert, configuré pour intégrer le signal en temps continu analogique ; dans lequel le modulateur comprend des moyens pour injecter un signal de porteuse dans une sortie de l'intégrateur, pour fournir un signal intermédiaire ; dans lequel le modulateur comprend un comparateur (1108) pour comparaison du signal intermédiaire ;

dans lequel le modulateur comprend un étage de sortie (1110) comprenant un circuit de filtrage ; dans lequel l'étage de sortie est couplé à une sortie du comparateur et dans lequel l'étage de sortie est configuré pour générer un signal d'alimentation de haut-parleur pour entraîner un haut-parleur pour le canal ; et

pour chaque canal, une boucle de commande de rétroaction (1122) configurée pour communiquer une première fonction de transfert ($H_4$ (s)) au signal d'alimentation de haut-parleur pour fournir un premier signal de commande pour moduler la caractéristique de transfert de l'intégrateur.

2. Amplificateur audio selon la revendication 1, comprenant en outre, pour chaque canal, une boucle de commande d'anticipation configurée pour appliquer une seconde fonction de transfert ($H_5$ (s)) sur le signal en temps continu analogique pour fournir un second signal de commande, dans lequel la caractéristique de transfert de l'intégrateur est configurée pour être modulée par une combinaison ou un rapport des premier et second signaux de commande.

3. Amplificateur audio selon la revendication 1 ou 2, dans lequel le dispositif logique programmable intégré comprend un dispositif à réseau de portes programmables *in situ* (FPGA) intégré dans l'amplificateur.

PROJECTOR
*102*

SOUND
PROCESSOR
*104*

POWER AMPS
*106*

*100*

*108*

*112*

*108*

*110*

*114*

*108*

# FIG. 1
*(PRIOR ART)*

PROJECTOR
202

200

SOUND
PROCESSOR
204

208

208

212

210

216

216

214

MULTI-CHANNEL
AMPLIFIER
206

208

## FIG. 2A

FIG. 2B

AMPLIFIER _304_

POWER SHARING
CONTROLLER
_306_

COMMON POWER
SUBSYSTEM
_308_

POWER SUPPLY 1

POWER SUPPLY 2

FAULT DETECTOR
_310_

ENVIRONMENTAL/
OPERATIONAL
MONITOR
_314_

RENDERER
_302_

_312_

MAINS
POWER
_320_

*FIG. 3*

CONTENT
404

INPUT
POWER
402

OUTPUT
POWER
410

Per-Channel
Gains (n)
412

SPEAKER
FAULT
408

ENVIRONMENT/
OPERATING
CONDITIONS
406

# FIG. 4A

*FIG. 4B*

**FIG. 5**

FIG. 6

**FIG. 7**

800

804    806    810    Content

802
Output    Controller    Fans    Amplifier    814
Output

Tach

808

812
Temperature sensors:
Per-channel, power
supplies, ambient and
predictive inputs

*FIG. 8*

Temperature

906

Set limit

902    Predicted
temperature
profile

904    Corrective action
by controller

Time

*FIG. 9*

AMPLIFIER *1000*

POWER SHARING
CONTROLLER
*306*

COMMON POWER
SUBSYSTEM
*308*

POWER SUPPLY 1

POWER SUPPLY 2

FAULT DETECTOR
*310*

ENVIRONMENTAL/
OPERATIONAL
MONITOR
*314*

N CLASS-D
AMPLIFICATION
MODULATORS w/
FPGA (FPGA 2)
*1002*

RENDERER
*302*

FPGA
*1102*
(FPGA 1)

NChannel
Speaker
Output

*FIG. 10*

**FIG. 11A**

*FIG. 11B*

1126

1130

H₁(S)

H₂(S)

1132

Variable
Current /
Resistance

Modulation
Control Input

**FIG. 11C**

FIG. 12

**FIG. 13**

FIG. 14

MAX_DUTY_CYCLE

PWM_IN

HS_PWM_OUT

LS_PWM_OUT

Duty Limiting

Signal to SW that
a Duty Limiting
Event Occurred

EP 3 408 936 B1

**FIG. 15**

EP 3 408 936 B1

*FIG. 16*

**HF Power Detection Module**

PMS Input CH0
PMS Input CH1
...
PMS Input CH7

1703

1704 PWM Sample

CLK

1706 High Pass Filter (64 Tap)

( . )^2

Σ

HF_NRGY

HF_ACCUM_DONE

SEL_CH

1700

1702

**FIG. 17**

**FIG. 18**

FIG. 19

**FIG. 20**

**FIG. 21**

**FIG. 22**

EP 3 408 936 B1

**FIG. 23**

**FIG. 24**

EP 3 408 936 B1

**FIG. 25**

EP 3 408 936 B1

**FIG. 26**

**REFERENCES CITED IN THE DESCRIPTION**

**Patent documents cited in the description**

- EP 16153471
- US 62289037 B
- US 62429682 B
- US 62429662 B
- US 62450543 B
- US 20100239102 A
- EP 2387149 A
- WO 2005099098 A
- US 20090160547 A
- US 61636429